# EUROPEAN PATENT APPLICATION

(11) **EP 4 290 686 A1**
(43) Date of publication of application: **13.12.2023**
(21) Application number: 22749764.1
(22) Date of filing: 02.02.2022
(51) Int. Cl.: H01Q 1/36, H01Q 13/08

(54) **ANTENNA AND COMMUNICATION DEVICE**

(30) Priority: 03.02.2021 JP 2021016102
(71) Applicant: Dai Nippon Printing Co., Ltd., Tokyo 162-8001 (JP)
(72) Inventor: NAKATA Naoko, Tokyo 162-8001 (JP); ISHIDA Taro, Tokyo 162-8001 (JP); AMAKAI Shinya, Tokyo 162-8001 (JP)
(74) Representative: Müller-Boré & Partner Patentanwälte PartG mbB
(86) International application number: PCT/JP2022/004139
(87) International publication number: WO 2022/168893

(57) **Abstract**

An antenna includes: a base that includes a first surface and a second surface located at an opposite side in relation to the first surface; a first conductor layer that includes a third surface facing the first surface, a fourth surface located at an opposite side in relation to the third surface, and a first side surface located between the third surface and the fourth surface; and a first cover layer that covers the fourth surface and the first side surface. The first side surface widens in such a way as to be displaced outward from the fourth surface toward the third surface. The first cover layer includes a first colored layer that includes a colorant.

## Description

### Technical Field

Embodiments of the present disclosure relate to an antenna and a communication apparatus.

### Background Art

In communication systems, an antenna that includes a base and a conductor layer over the base is used. For example, PTL 1 proposes the use of a patch antenna as an antenna apparatus in a mobile communication system.

### Citation List

### Patent Literature

PTL 1: Pamphlet of International Publication No. 2018/230039

### Summary of Invention

### Technical Problem

The higher the frequency is, the shorter the propagation distance of a radio wave is. For example, when a millimeter wave is used, the distance of communication using an antenna is approximately 100 m. Moreover, the higher the frequency is, the greater the linear traveling property of a radio wave is, making it more likely for the radio wave to be blocked by an object. For this reason, the higher the frequency is, the larger the number of antennas installed is.

As the number of antennas installed increases, so does the possibility that an antenna will be visually noticed. The appearance of the antenna should preferably be adjustable.

Embodiments of the present disclosure have been devised in consideration of this point and aim to provide an antenna whose appearance is adjustable.

### Solution to Problem

An antenna according to an embodiment of the present disclosure includes: a base that includes a first surface and a second surface located at an opposite side in relation to the first surface; a first conductor layer that includes a third surface facing the first surface, a fourth surface located at an opposite side in relation to the third surface, and a first side surface located between the third surface and the fourth surface; and a first cover layer that covers the fourth surface and the first side surface, wherein the first side surface includes a first end connected to the third surface and a second end connected to the fourth surface, the first end is located outward of the second end in a plan view, and the first cover layer includes a first colored layer that includes a colorant.

The antenna according to an embodiment of the present disclosure may further include a ground that includes a second conductor layer located at the second surface side with respect to the base. The ground may include a second perimeter located outward of the first side surface in a plan view.

In the antenna according to an embodiment of the present disclosure, the first side surface may include an inward curved surface located inward of a virtual straight line passing through the first end and the second end in a cross-sectional view.

In the antenna according to an embodiment of the present disclosure, the first side surface may form a first angle with respect to the third surface at the first end, the first side surface may form a second angle with respect to the fourth surface at the second end, and a sum of the first angle and the second angle may be greater than 90° but less than 175°.

In the antenna according to an embodiment of the present disclosure, the second angle may be 135° or less.

In the antenna according to an embodiment of the present disclosure, the first side surface may include an outward curved surface located outward of a virtual straight line passing through the first end and the second end in a cross-sectional view.

In the antenna according to an embodiment of the present disclosure, the first side surface may form a first angle with respect to the third surface at the first end, the first side surface may form a second angle with respect to the fourth surface at the second end, and a sum of the first angle and the second angle may be greater than 185° but less than 270°.

In the antenna according to an embodiment of the present disclosure, the first side surface may include a flat surface.

In the antenna according to an embodiment of the present disclosure, the first side surface may form a first angle with respect to the third surface at the first end, the first side surface may form a second angle with respect to the fourth surface at the second end, and a sum of the first angle and the second angle may be 175° or greater and 185° or less.

In the antenna according to an embodiment of the present disclosure, the first side surface may include an eleventh side surface and a twelfth side surface connected to the eleventh side surface at a first connection portion and located between the first connection portion and the fourth surface.

In the antenna according to an embodiment of the present disclosure, the eleventh side surface or the twelfth side surface may include an inward curved surface located inward of a virtual straight line passing through the first end and the second end in a cross-sectional view.

In the antenna according to an embodiment of the present disclosure, the eleventh side surface or the twelfth side surface may include an outward curved surface located outward of a virtual straight line passing through the first end and the second end in a cross-sectional view.

In the antenna according to an embodiment of the present disclosure, the eleventh side surface or the twelfth side surface may include a flat surface.

In the antenna according to an embodiment of the present disclosure, the first cover layer may include an upper surface parallel to the first surface.

In the antenna according to an embodiment of the present disclosure, the first colored layer may include a lower surface parallel to the first surface.

In the antenna according to an embodiment of the present disclosure, the first cover layer may include a layer that is in contact with the first side surface and includes an upper surface including a step overlapping with the first side surface in a plan view.

In the antenna according to an embodiment of the present disclosure, the first cover layer may include an upper surface including a step overlapping with the first side surface in a plan view.

In the antenna according to an embodiment of the present disclosure, the first colored layer may be in contact with the fourth surface and the first side surface.

In the antenna according to an embodiment of the present disclosure, the first cover layer may include a first pressure sensitive adhesive layer located between the first conductor layer and the first colored layer and being in contact with the fourth surface and the first side surface.

In the antenna according to an embodiment of the present disclosure, the first cover layer may include a second colored layer that includes a colorant.

In the antenna according to an embodiment of the present disclosure, the first cover layer may include a second pressure sensitive adhesive layer located between the first colored layer and the second colored layer.

In the antenna according to an embodiment of the present disclosure, the first cover layer may include a first transparent layer located between the first colored layer and the second colored layer.

In the antenna according to an embodiment of the present disclosure, the first conductor layer may include a patch and wiring connected to the patch, and a slit may be formed between the patch and the wiring.

In the antenna according to an embodiment of the present disclosure, the patch may be configured to deal with transmission or reception of a radio wave having a frequency of 300 MHz or higher.

The antenna according to an embodiment of the present disclosure may further include: a third conductor layer facing the fourth surface of the first conductor layer.

The antenna according to an embodiment of the present disclosure may further include: a third cover layer covering the third conductor layer, wherein the third cover layer may include a colorant.

A communication apparatus according to an embodiment of the present disclosure includes: a structure body that includes a surface; and the above-described antenna attached to the surface.

In the communication apparatus according to an embodiment of the present disclosure, the surface of the structure body may include a curved surface, and the antenna may be attached to a curved surface.

### Advantageous Effects of Invention

Embodiments of the present disclosure make it possible to provide an antenna whose appearance is adjustable.

### Brief Description of Drawings

[Fig. 1] Fig. 1 is a diagram that illustrates an example of a communication system.
[Fig. 2A] Fig. 2A is a diagram that illustrates an example of a communication apparatus.
[Fig. 2B] Fig. 2B is a diagram that illustrates an example of a communication apparatus.
[Fig. 3] Fig. 3 is a diagram that illustrates an example of an antenna.
[Fig. 4] Fig. 4 is a diagram that illustrates the antenna illustrated in Fig. 3, with a first cover layer removed therefrom.
[Fig. 5] Fig. 5 is a cross-sectional view, viewed in a V-V-direction, of the antenna illustrated in Fig. 3.
[Fig. 6] Fig. 6 is an enlarged cross-sectional view of a first side surface of a first conductor layer illustrated in Fig. 5.
[Fig. 7A] Fig. 7A is a plan view of an example of a patch.
[Fig. 7B] Fig. 7B is a plan view of an example of a patch.
[Fig. 8] Fig. 8 is a diagram that illustrates an example of a method of manufacturing an antenna.
[Fig. 9] Fig. 9 is a diagram that illustrates an example of a method of manufacturing an antenna.
[Fig. 10] Fig. 10 is a diagram that illustrates an example of a method of processing the first conductor layer.
[Fig. 11] Fig. 11 is a diagram that illustrates an example of a method of processing the first conductor layer.
[Fig. 12] Fig. 12 is a cross-sectional view of a first side surface of the first conductor layer according to a variation example.
[Fig. 13] Fig. 13 is a cross-sectional view of a first side surface of the first conductor layer according to a variation example.
[Fig. 14] Fig. 14 is a cross-sectional view of a first side surface of the first conductor layer according to a variation example.
[Fig. 15] Fig. 15 is a cross-sectional view of a first side surface of the first conductor layer according to a variation example.
[Fig. 16] Fig. 16 is a cross-sectional view of a first side surface of the first conductor layer according to a variation example.
[Fig. 17] Fig. 17 is a cross-sectional view of a first side surface of the first conductor layer according to a variation example.
[Fig. 18] Fig. 18 is a cross-sectional view of a first side surface of the first conductor layer according to a variation example.
[Fig. 19] Fig. 19 is a cross-sectional view of a first cover layer according to a variation example.
[Fig. 20] Fig. 20 is a cross-sectional view of a first cover layer according to a variation example.
[Fig. 21A] Fig. 21A is a cross-sectional view of a first cover layer according to a variation example.
[Fig. 21B] Fig. 21B is a cross-sectional view of a first cover layer according to a variation example.
[Fig. 21C] Fig. 21C is a cross-sectional view of a first cover layer according to a variation example.
[Fig. 22] Fig. 22 is a cross-sectional view of a first cover layer according to a variation example.
[Fig. 23] Fig. 23 is a cross-sectional view of a first cover layer according to a variation example.
[Fig. 24] Fig. 24 is a cross-sectional view of a first cover layer according to a variation example.
[Fig. 25] Fig. 25 is a cross-sectional view of a first cover layer according to a variation example.
[Fig. 26] Fig. 26 is a cross-sectional view of an antenna according to a variation example.
[Fig. 27] Fig. 27 is a cross-sectional view of an example of a surface layer.
[Fig. 28] Fig. 28 is a cross-sectional view of an antenna according to a variation example.
[Fig. 29] Fig. 29 is a cross-sectional view of an antenna according to a variation example.
[Fig. 30] Fig. 30 is a diagram that illustrates an example of a method of manufacturing an antenna.
[Fig. 31] Fig. 31 is a diagram that illustrates an example of the method of manufacturing an antenna.
[Fig. 32] Fig. 32 is a diagram that illustrates an example of the method of manufacturing an antenna.
[Fig. 33] Fig. 33 is a diagram that illustrates an example of the method of manufacturing an antenna.
[Fig. 34] Fig. 34 is a diagram that illustrates an example of a method of manufacturing an antenna.
[Fig. 35] Fig. 35 is a diagram that illustrates an example of the method of manufacturing an antenna.
[Fig. 36] Fig. 36 is a diagram that illustrates an example of the method of manufacturing an antenna.
[Fig. 37] Fig. 37 is a diagram that illustrates a patch according to variation examples.
[Fig. 38] Fig. 38 is a diagram that illustrates a patch according to a variation example.
[Fig. 39A] Fig. 39A is a diagram that illustrates an antenna according to a variation example.
[Fig. 39B] Fig. 39B is a diagram that illustrates an antenna according to a variation example.
[Fig. 39C] Fig. 39C is a diagram that illustrates an antenna according to a variation example.
[Fig. 39D] Fig. 39D is a diagram that illustrates an antenna according to a variation example.
[Fig. 39E] Fig. 39E is a diagram that illustrates an antenna according to a variation example.
[Fig. 40] Fig. 40 is a diagram that illustrates an evaluation result of the resonance frequency of an antenna.
[Fig. 41] Fig. 41 is a diagram that illustrates an evaluation result of the radiation efficiency of an antenna.
[Fig. 42] Fig. 42 is a diagram that illustrates an evaluation result of the characteristics of an antenna.

### Description of Embodiments

A configuration of an antenna 10 according to an embodiment of the present disclosure will now be described in detail while referring to the drawings. The embodiment described below is just an example of embodiments of the present disclosure, and the present disclosure shall not be construed to be limited to the embodiments. Terms such as "substrate", "base", "sheet", and "film" in this description, etc. are not distinguished from one another based on differences in nominal designation only. For example, the concept of "substrate" and "base" encompasses members that are termed as "sheet" or "film". Moreover, terms that are used in this description to specify shapes and geometric conditions, and the extent thereof, for example, terms such as "parallel" and "orthogonal", and values of length, angle, and the like, shall be construed each to encompass a range in which a similar function can be expected, without being bound to its strict sense.

In this description, when a plurality of candidates for an upper limit value and a plurality of candidates for a lower limit value regarding a certain parameter are mentioned, the numerical range of this parameter may be constructed by combining any one candidate for the upper limit value and any one candidate for the lower limit value. For example, suppose that a sentence says, "The parameter B is, for example, A1 or greater, or may be A2 or greater, or A3 or greater; the parameter B is, for example, A4 or less, or may be A5 or less, or A6 or less." In this case, the numerical range of the parameter B may be A1 or greater and A4 or less, A1 or greater and A5 or less, A1 or greater and A6 or less, A2 or greater and A4 or less, A2 or greater and A5 or less, A2 or greater and A6 or less, A3 or greater and A4 or less, A3 or greater and A5 or less, or A3 or greater and A6 or less.

In the drawings referred to in the present embodiment, the same or similar reference signs may be assigned to the same portions or portions having similar functions, and duplicative explanation may be omitted. Dimensional ratios in the drawings may be made different from actual ratios for easier understanding, or a part of a configuration may be omitted from the drawings.

An embodiment of the present disclosure will be described below.

Recently, high-frequency radio waves such as microwaves, millimeter waves, quasi-millimeter waves have begun to be used in various fields. Microwaves are radio waves in a frequency band of approximately 0.3 GHz or higher and 300 GHz or lower. Millimeter waves are radio waves in a frequency band of approximately 30 GHz or higher and 300 GHz or lower. Quasi-millimeter waves are radio waves in a frequency band of approximately 10 GHz or higher and 30 GHz or lower. Examples of fields are fifth-generation mobile communication systems and mobiles, communication systems for vehicles, radars for anti-collision systems, medical biological sensing, and the like.

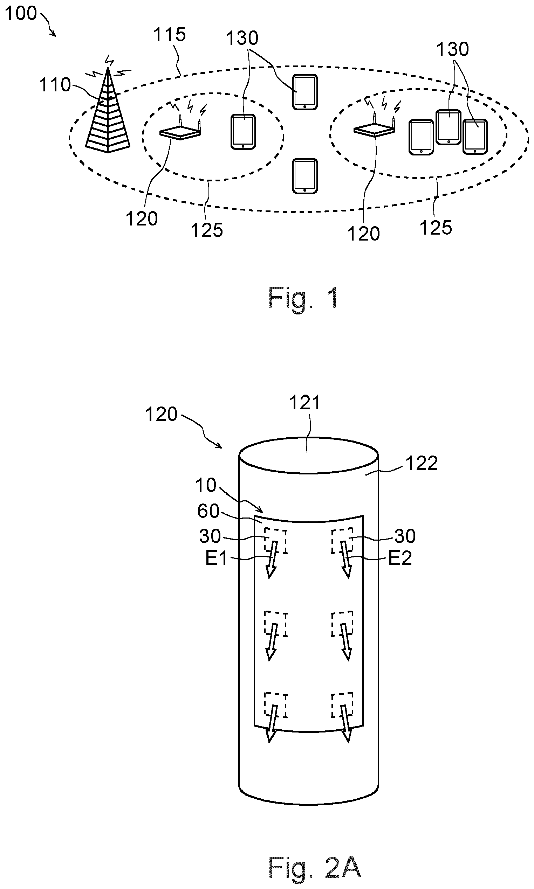

Fig. 1 is a diagram that illustrates an example of a mobile communication system 100. The mobile communication system 100 includes a base station 110, a plurality of communication apparatuses 120, and a plurality of terminal apparatuses 130. The base station 110 is also called a macrocell and performs wireless communication with communication apparatuses and terminal apparatuses 130 located in an area 115. The communication apparatus 120 is also called a small cell and performs wireless communication with terminal apparatuses 130 located in an area 125. The base station 110 and the communication apparatuses 120 include antennas. The terminal apparatus 130 is, for example, a smartphone. As illustrated in Fig. 1, the area 125 served by each communication apparatus 120, which is a small cell, may be located inside the area 115, which is served by the macrocell. Though not illustrated, the area 125, which is served by the small cell, may be located partially outside the area 115, which is served by the macrocell. In this description, a small cell means a communication apparatus that serves an area smaller than a macrocell. The small cell may be a socalled femtocell, nanocell, picocell, microcell, or the like.

Fig. 2A is a diagram that illustrates an example of the communication apparatus 120. The communication apparatus 120 includes a structure body 121, which includes a surface 122, and an antenna 10, which is attached to the surface 122. Attaching the antenna 10 to the structure body 121 enables the structure body 121 to have a communication function.

Though not illustrated, the communication apparatus 120 may include a controller that controls a radio wave transmitted by the antenna 10. In addition, the communication apparatus 120 may include a processor that processes a radio wave received by the antenna 10. The controller and the processor may be provided on a common base shared with the antenna 10. Alternatively, the controller and the processor may be provided on a member different from the member on which the antenna 10 is provided.

The higher the frequency is, the shorter the propagation distance of a radio wave is. For example, when a millimeter wave is used, the distance of communication using an antenna is approximately 100 m. Moreover, the higher the frequency is, the greater the linear traveling property of a radio wave is, making it more likely for the radio wave to be blocked by an object. For this reason, the higher the frequency is, the larger the number of the communication apparatuses 120 installed is.

As the number of the communication apparatuses 120 installed increases, so does the possibility that the antenna 10 will be visually noticed. That is, the possibility that the antenna 10 will be installed on a structure body 121 that catches the public eyes increases. The structure body 121 is, for example, an indoor pillar in commercial facilities, a support for a traffic light or a smart street lamp, or the like. The structure body 121 may include a curved surface. The structure body 121 such as a pillar or a support has a curved cross-sectional shape taken along a horizontal plane, for example, a circular cross-sectional shape.

When the antenna 10 is installed at a place where people can see it, the appearance of the antenna 10 should preferably be adjustable. For example, the antenna 10 should preferably have appearance that is well-harmonized with its ambient environment. Proposed in the present embodiment is to adjust the appearance of the antenna 10 by using a first cover layer 60. Specifically, as illustrated in Fig. 2A, the antenna 10 includes a patch 30 and the first cover layer 60 covering the patch 30. The patch 30 transmits or receives a radio wave. The patch 30 is also called a patch element. The first cover layer 60 has a pattern. For example, the first cover layer 60 has a pattern that is similar to the pattern of the surface 122 of the communication apparatus 120. This makes it possible to suppress the appearance of the structure body 121 from being impaired by the antenna 10.

As illustrated in Fig. 2A, the communication apparatus 120 may include a plurality of patches 30. As illustrated in Fig. 2A, a single first cover layer 60 may cover a plurality of patches 30.

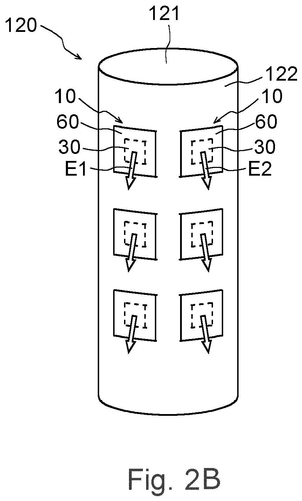

Fig. 2B is a diagram that illustrates another example of the communication apparatus 120. As illustrated in Fig. 2B, one first cover layer 60 may cover one patch 30.

The arrangement direction of the plurality of patches 30, the arrangement pitch thereof, and the like, may be determined based on the radiation angle of the patch 30. For example, when the plural patches 30 are arranged in a circumferential direction, a circumferential angle calculated based on two patches 30 located next to each other in the circumferential direction may be the radiation angle of the patch 30 or less. The circumferential angle is an angle formed by a first line segment, which connects the center of a first patch and the center of the structure body 121, and a second line segment, which connects the center of a second patch located next to the first patch in the circumferential direction and the center of the structure body 121.

The curvature radius of the curved surface of the structure body 121 is, for example, (1/2) × (Cf / (π × F)) mm or greater, or may be (3/4) × (Cf / (π × F)) mm or greater, or Cf / (π × F) mm or greater. The curvature radius of the curved surface of the structure body 121 is, for example, 2000 mm or less, or may be 1000 mm or less, or 200 mm or less. "F" denotes the maximum value of the frequency of a radio wave transmitted or received by the antenna 10; this value is expressed in units of GHz. "Cf" denotes the propagation velocity of an electromagnetic wave, specifically, 299792458 [m/s].

The curvature radius that the antenna 10 can operate depends on the flexibility of the antenna 10, the frequency of a radio wave transmitted or received by the antenna 10, and the like. For example, the higher the frequency is, the smaller the size of the patch 30 is. The smaller the size of the patch 30 is, the easier the installation of the antenna 10 on a curved surface having a small curvature radius is.

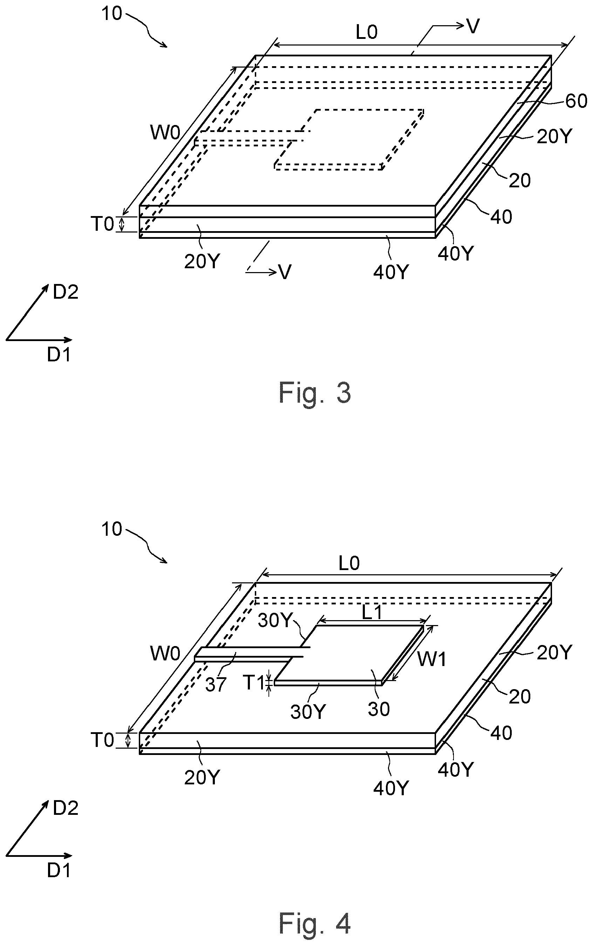

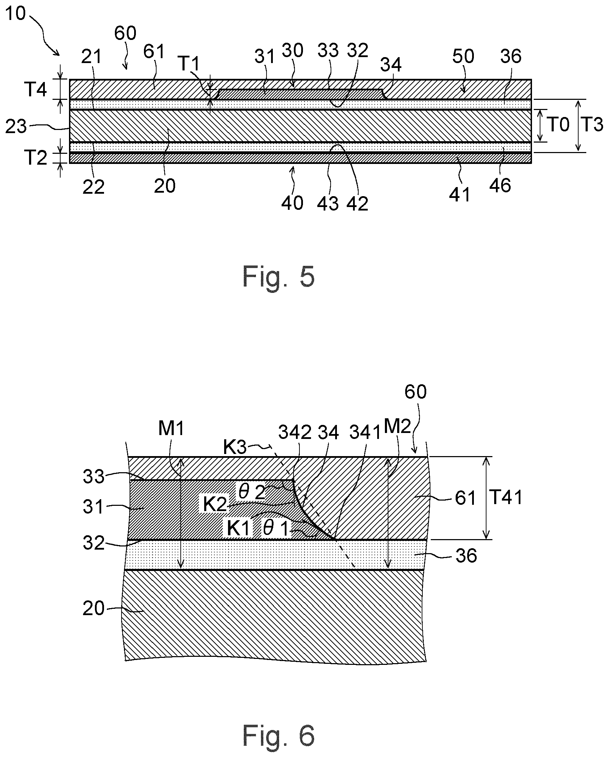

Fig. 3 is a diagram that illustrates an example of the antenna 10. Fig. 4 is a diagram that illustrates the antenna 10 illustrated in Fig. 3, with the first cover layer 60 removed therefrom. Fig. 5 is a cross-sectional view, viewed in a V-V-direction, of the antenna 10 illustrated in Fig. 3.

The antenna 10 includes a base 20, the patch 30, and the first cover layer 60. The antenna 10 may include a ground 40. As illustrated in Fig. 5, the base 20 includes a first surface 21, a second surface 22, and side surfaces 23. The second surface 22 is located at the opposite side in relation to the first surface 21. The side surface 23 extends from the first surface 21 to the second surface 22. The patch 30 is located at the first surface 21 side. The first cover layer 60 covers the patch 30 at the first surface 21 side. Though not illustrated, the first cover layer 60 may cover the side surface 23 of the base 20. The first cover layer 60 may cover a part of the side surface 23 or the whole of the side surface 23. The ground 40 is located at the second surface 22 side. The base 20 and the first cover layer 60 have insulating property. The patch 30 and the ground 40 have conductive property. The base 20, the patch 30, and the ground 40 constitute a capacitor-type antenna. The first cover layer 60 has an influence on the characteristics of the antenna 10. The characteristics of the antenna 10 are: resonance frequency, gain, radiation efficiency, radiation pattern, and the like.

The frequency of a radio wave transmitted or received by the antenna 10 is, for example, 300 MHz or higher, or may be 3 GHz or higher, 25 GHz or higher, or 50 GHz or higher. The frequency of a radio wave transmitted or received by the antenna 10 is, for example, 110 GHz or lower, or may be 80 GHz or lower. Such a radio wave is used in a fifth-generation mobile communication system, a vehicle-to-vehicle communication system, a radar device for vehicular use, and the like.

As illustrated in Fig. 5, the antenna 10 may include a first adhesive layer 36 located between the base 20 and the patch 30. In addition, the antenna 10 may include a second adhesive layer 46 located between the base 20 and the ground 40.

Each constituting element of the antenna 10 will now be described.

### (Base)

The base 20 may have flexibility. In this case, it is possible to attach the antenna 10 to the structure body 121 having a curved surface.

As illustrated in Figs. 3 and 4, the base 20 may have a quadrangular perimeter in a plan view. For example, the base 20 may include a perimeter 20Y extending in a first direction D1 and a second direction D2 orthogonal to the first direction D1. "A plan view" means that the antenna 10 is viewed in a direction of a line that is normal to the first surface 21.

The base 20 contains a resin material that has a low relative dielectric constant. The relative dielectric constant of the base 20 may be 4.0 or less, 3.5 or less, 3.0 or less, 2.5 or less, or 2.0 or less. This makes it possible to enhance the radiation efficiency and gain of the antenna 10. The relative dielectric constant of the base 20 may be 1.0 or greater, or 1.5 or greater.

The dielectric loss tangent tanδ of the base 20 may be 0.01 or less, 0.005 or less, 0.001 or less, or 0.0005 or less.

As the resin material of the base 20, a fluororesin, a liquid crystal polymer (LCP), polypropylene (PP), modified polypropylene (modified PP), polyimide (PI), or the like can be used. Examples of a fluororesin are: a completely fluorinated resin such as polytetrafluoroethylene (PTFE), a partially fluorinated resin such as polychlorotrifluoroethylene (PCTFE), a fluorinated resin copolymer such as an ethylene-tetrafluoroethylene copolymer (ETFE), and the like. A fluororesin has a relative dielectric constant of, for example, 2.0 or greater and 3.0 or less. A liquid crystal polymer has a relative dielectric constant of, for example, 2.9 or greater and 3.7 or less. Polypropylene has a relative dielectric constant of, for example, 2.2 or greater and 2.6 or less. Polyimide has a relative dielectric constant of approximately 3.5. The values of the relative dielectric constant according to the present application are values measured at an ambient temperature of 20°C and at a frequency of a radio wave of 10 GHz.

The base 20 may be made up of a single layer or a plurality of layers.

The thickness T0 of the base 20 is, for example, 10 mm or less, or may be 5 mm or less, 2 mm or less, or 1 mm or less. The thickness T0 of the base 20 is, for example, 10 µm or greater, or may be 20 µm or greater, 50 µm or greater, or 100 µm or greater.

Though not illustrated, the base 20 may contain a plurality of air bubbles. That is, the base 20 may contain a foam resin. This makes it possible to reduce the relative dielectric constant of the base 20.

### (Patch)

As illustrated in Fig. 4, the patch 30 includes a first perimeter 30Y, which is located inward of the perimeter 20Y of the base 20 in a plan view. The first perimeter 30Y may have a quadrangular shape in a plan view. For example, the first perimeter 30Y may extend in the first direction D1 and the second direction D2 intersecting with the first direction D1. The second direction D2 may be orthogonal to the first direction D1.

As illustrated in Fig. 4, wiring 37 may be connected to the patch 30. The wiring 37 is, for example, a microstrip line.

In Fig. 4, the reference sign L1 denotes the dimension of the patch 30 in the first direction D1. The reference sign W1 denotes the dimension of the patch 30 in the second direction D2. The dimension L1, W1 is, for example, 50 mm or less, or may be 20 mm or less, 10 mm or less, or 1 mm or less. The dimension L1, W1 may be, for example, 0.2 mm or greater.

The dimension L1 or W1 may be determined based on the frequency of a radio wave transmitted or received by the antenna 10. In the antenna 10 illustrated in Fig. 4, the wiring 37 is connected to an edge of the patch 30 extending in the second direction D2. In this case, the patch 30 can function as an antenna that resonates in the first direction D1. In this case, the dimension L1, which is the size of the patch 30 in the first direction D1, should preferably be determined based on the frequency of a radio wave transmitted or received by the antenna 10.

In a case where the frequency of the radio wave is 300 MHz or higher and 3 GHz or lower, the dimension L1 may be 20 mm or greater and 500 mm or less.

In a case where the frequency of the radio wave is 3 GHz or higher and 6 GHz or lower, the dimension L1 may be 10 mm or greater and 50 mm or less.

In a case where the frequency of the radio wave is 6 GHz or higher and 25 GHz or lower, the dimension L1 may be 2.5 mm or greater and 30 mm or less.

In a case where the frequency of the radio wave is 25 GHz or higher and 30 GHz or lower, the dimension L1 may be 2 mm or greater and 20 mm or less.

In a case where the frequency of the radio wave is 50 GHz or higher and 75 GHz or lower, the dimension L1 may be 0.5 mm or greater and 10 mm or less.

In a case where the frequency of the radio wave is 75 GHz or higher and 300 GHz or lower, the dimension L1 may be 0.2 mm or greater and 5.0 mm or less.

The dimension L1 may be the same as the dimension W1 or different therefrom. The dimension W1 may be determined based on the frequency of a radio wave transmitted or received by the antenna 10, or may be determined irrespectively of the frequency. In a case where the dimension L1 is determined based on the frequency of a radio wave transmitted or received by the antenna 10, the above-described numerical range of the dimension L1 can be adopted as the numerical range of the dimension W1.

In Fig. 4, the reference sign L0 denotes the dimension of the base 20 in the first direction D1. The reference sign W0 denotes the dimension of the base 20 in the second direction D2. The dimension L0, W0 is greater than the dimension L1, W1. For example, the dimension L0, W0 may be twice or more, or three times or more, the dimension L1, W1.

As illustrated in Fig. 5, the patch 30 includes a first conductor layer 31, which is located at the first surface 21 side with respect to the base 20. The first conductor layer 31 includes a third surface 32, a fourth surface 33, and first side surfaces 34. The third surface 32 faces the first surface 21 of the base 20. The fourth surface 33 is located at the opposite side in relation to the third surface 32. The first side surface 34 is located between the third surface 32 and the fourth surface 33. The first side surfaces 34 constitute the first perimeter 30Y of the patch 30 in a plan view.

The wiring 37 described above also may include the first conductor layer 31. That is, the patch 30 and the wiring 37 may include a common first conductor layer 31.

The first conductor layer 31 contains a material that has conductive property. For example, the first conductor layer 31 contains a metal material such as copper (Cu), gold (Au), silver (Ag), aluminum (Al), etc. or alloy using these kinds of metal, etc. The first conductor layer 31 may contain a transparent conductive material such as indium tin oxide (ITO) or indium zinc oxide (IZO). The first conductor layer 31 may contain a carbon-based conductive material such as graphite, carbon nanotube, graphene, or fullerene.

The method of forming the first conductor layer 31 is not specifically limited. For example, a plating method, a printing method, a sputtering method, a vapor deposition method, or the like may be used for forming the first conductor layer 31. A foil that constitutes the first conductor layer 31 may be pasted onto the base 20, with the first adhesive layer 36 therebetween. The foil may be manufactured using an electrolytic deposition method, a rolling method, or the like.

The thickness T1 of the first conductor layer 31 may be 1 µm or greater, or 5 µm or greater. The thickness T1 of the first conductor layer 31 may be 35 µm or less, or 20 µm or less.

The surface of the first conductor layer 31 should preferably have a small surface roughness. This makes it possible to reduce transmission loss occurring at the patch 30. For example, the surface roughness in maximum height (Rz) of the third surface 32 of the first conductor layer 31 may be 3.0 µm or less, 2.0 µm or less, or 1.0 µm or less. Configuring the surface roughness in maximum height (Rz) of the third surface 32 to be 3.0 µm or less makes it possible to reduce the transmission loss of the patch 30 at 20 GHz to, for example, 6 dB or less.

The arithmetic mean roughness (Ra) of the third surface 32 of the first conductor layer 31 may be 3.0 µm or less, 2.0 µm or less, or 1.0 µm or less.

The smaller the arithmetic mean roughness (Ra) and the surface roughness in maximum height (Rz) of the third surface 32 are, the lower the degree of close contact of the third surface 32 with the first surface 21 of the base 20 might be. With this considered, it is preferable to provide the first adhesive layer 36 between the first surface 21 and the third surface 32. By this means, even in a case where the arithmetic mean roughness (Ra) and the surface roughness in maximum height (Rz) of the third surface 32 are small, it is possible to suppress the patch 30 from coming off.

The arithmetic mean roughness (Ra) and the surface roughness in maximum height (Rz) are defined based on JIS B 0601: 2013.

Fig. 6 is an enlarged cross-sectional view of the first side surface 34 of the first conductor layer 31 illustrated in Fig. 5. The first side surface 34 widens in such a way as to be displaced outward from the fourth surface 33 toward the third surface 32. For this reason, the first side surface 34 is not hidden by the fourth surface 33 in a plan view. This makes it easier for the first cover layer 60 to be in contact with the first side surface 34 when the first cover layer 60 is formed in such a way as to cover the fourth surface 33 and the first side surface 34. For this reason, it is possible to suppress a gap from being formed between the first side surface 34 and the first cover layer 60. The term "outward" means a directional side of going from the center of the patch 30 toward the first perimeter 30Y in a plan view. The term "inward" to be mentioned later means a directional side of going from the first perimeter 30Y toward the center of the patch 30 in a plan view.

When there is a gap between the first side surface 34 and the first cover layer 60, the gap also has an influence on the characteristics of the antenna 10. For example, based on the permittivity of air, a gap has an influence on the characteristics of the antenna 10. The shape, volume, etc. of a gap changes depending on an ambient temperature, the temperature of the antenna 10, etc. For example, the higher the ambient temperature is, the greater the volume of the gap is, due to expansion of air. As the volume of the gap changes, so do the characteristics of the antenna 10. For this reason, if a gap exists between the first side surface 34 and the first cover layer 60, the characteristics of the antenna 10 could be unstable.

With the present embodiment, by ingeniously designing the shape of the first side surface 34, it is possible to suppress a gap from being formed between the first side surface 34 and the first cover layer 60. This makes it possible to stabilize the characteristics of the antenna 10. For example, it is possible to suppress a change in resonance frequency and radiation efficiency of the antenna 10 in accordance with a change in ambient temperature.

The first side surface 34 includes a first end 341 connected to the third surface 32 and a second end 342 connected to the fourth surface 33. The first end 341 is located outward of the second end 342 in a plan view. As illustrated in Fig. 6, the first side surface may include a curved surface that is convex inward. The meaning of "convex inward" is that, in a cross-sectional view, the first side surface 34 is located inward of a virtual straight line K3 passing through the first end 341 and the second end 342. A curved surface that is convex inward will also be called an inward curved surface. The first side surface 34 may be an inward curved surface that extends from the first end 341 to the second end 342.

In Fig. 6, the reference sign θ1 denotes an angle formed at the first end 341 by the first side surface 34 with respect to the third surface 32 (also called a first angle). The first angle θ1 is an angle between a tangential line K1, which is tangential to the first side surface 34 at the first end 341, and the third surface 32. The first angle θ1 is less than 90°. In a case where the first side surface 34 is an inward curved surface, the first angle θ1 is, for example, 45° or less, or may be 40° or less, or 35° or less. The first angle θ1 is, for example, 5° or greater, or may be 10° or greater, or 15° or greater.

In Fig. 6, the reference sign θ2 denotes an angle formed at the second end 342 by the first side surface 34 with respect to the fourth surface 33 (also called a second angle). The second angle θ2 is an angle between a tangential line K2, which is tangential to the first side surface 34 at the second end 342, and the fourth surface 33. The second angle θ2 is greater than 90°. In a case where the first side surface 34 is an inward curved surface, the second angle θ2 is, for example, 95° or greater, or may be 100° or greater, or 105° or greater. The second angle θ2 is, for example, 135° or less, or may be 130° or less, or 125° or less.

In a case where the first side surface 34 is an inward curved surface, the sum of the first angle θ1 and the second angle θ2 is greater than 90° but less than 175°. The sum of the first angle θ1 and the second angle θ2 is, for example, 95° or greater, or may be 100° or greater, or 105° or greater. The sum of the first angle θ1 and the second angle θ2 is, for example, 145° or less, or may be 140° or less, or 135° or less.

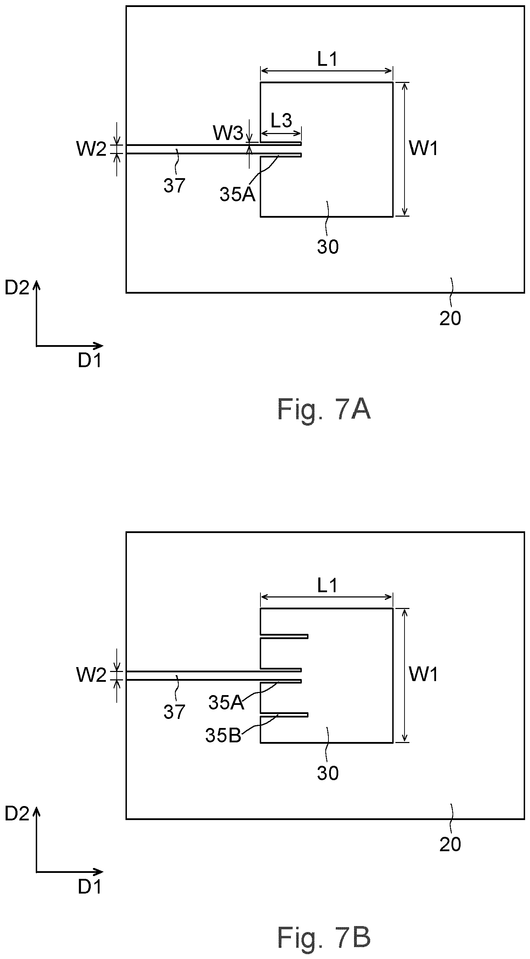

Fig. 7A is a plan view of an example of the patch 30. As illustrated in Fig. 7A, slits 35A may be formed between the patch 30 and the wiring 37 in a plan view. The size of the slit 35A has an influence on the characteristics of the antenna 10.

The first side surface 34 facing the slit 35A also may be configured to widen in such a way as to be displaced outward from the fourth surface 33 toward the third surface 32. This makes it possible to suppress a gap from being formed between the first side surface 34 and the first cover layer 60 at the position of the slit 35A.

The length L3 of the slit 35A may be set arbitrarily as long as impedance matching is achieved; for example, it is 20 mm or less, or may be 10 mm or less, or 5 mm or less. The length L3 of the slit 35A is, for example, 1 mm or greater, or may be 2 mm or greater, or 3 mm or greater.

The width W3 of the slit 35A is, for example, 2 mm or less, or may be 1 mm or less, 0.8 mm or less, or 0.5 mm or less. The width W3 of the slit 35A is, for example, 0.01 mm or greater, or may be 0.05 mm or greater, or 0.1 mm or greater.

The ratio L3/W3, which is the ratio of the length L3 to the width W3, is, for example, 2 or higher, or may be 5 or higher, or 10 or higher. The ratio L3/W3 is, for example, 100 or lower, or may be 50 or lower, or 30 or lower.

Fig. 7B is a plan view of another example of the patch 30. As illustrated in Fig. 7B, slits 35B may be formed in the patch 30 at positions of not being adjacent to the wiring 37. The size of the slit 35B also has an influence on the characteristics of the antenna 10.

The first side surface 34 facing the slit 35B, similarly to the slit 35A, also may be configured to widen in such a way as to be displaced outward from the fourth surface 33 toward the third surface 32. This makes it possible to suppress a gap from being formed between the first side surface 34 and the first cover layer 60 at the position of the slit 35B. The shape of the patch 30 including the slits 35B is also called "E-Shape."

The length of the slit 35B may be within the range of the length L3 whose examples have been described about the slit 35A. The length of the slit 35B may be greater than the length L3 of the slit 35A. The width of the slit 35B may be within the range of the width W3 whose examples have been described about the slit 35A. The ratio of the length of the slit 35B to the width thereof may be within the range of L3/W3 whose examples have been described about the slit 35A.

### (First Adhesive Layer)

The first adhesive layer 36 is located between the first surface 21 of the base 20 and the third surface 32 of the patch 30. The first adhesive layer 36 bonds the first surface 21 and the third surface 32 to each other. As illustrated in Fig. 4, the first adhesive layer 36 may extend to the outer side beyond the first perimeter 30Y of the patch 30. That is, the first adhesive layer 36 may include an area that does not overlap with the patch 30 in a plan view.

The first adhesive layer 36 is selected suitably for an environment in which the antenna is used, the first cover layer 60, and the base 20. The first adhesive layer 36 may include a fluorine-based adhesive containing a fluororesin. For example, the first adhesive layer 36 may contain a carboxyl-group-containing styrene-based elastomer, an epoxy resin, or the like. The relative dielectric constant of the first adhesive layer 36 may be 4.0 or less, 3.5 or less, 3.0 or less, 2.5 or less, or 2.0 or less. The relative dielectric constant of the first adhesive layer 36 may be 1.0 or greater, or 1.5 or greater.

The dielectric loss tangent tanδ of the first adhesive layer 36 may be 0.01 or less, 0.005 or less, 0.001 or less, or 0.0005 or less.

The thickness of the first adhesive layer 36 is, for example, 30 µm or less, or may be 25 µm or less, or 20 µm or less. The thickness of the first adhesive layer 36 is, for example, 2 µm or greater, or may be 5 µm or greater, or 10 µm or greater. The thickness of the first adhesive layer 36 may be further increased, for example, 50 µm or greater, or 100 µm.

An adhesive such as a fluorine-based adhesive may constitute the base 20. For example, the first conductor layer 31 and a second conductor layer 41 may be provided on the first surface 21 and the second surface 22 of the base 20 obtained by solidifying the adhesive.

### (First Cover Layer)

As illustrated in Figs. 5 and 6, the first cover layer 60 covers the fourth surface 33 and the first side surface 34 of the first conductor layer 31. Preferably, the first cover layer 60 should be in contact with the fourth surface 33 and the first side surface 34 without any gap therebetween. The first cover layer 60 may be in contact with the entire area of the fourth surface 33 and the first side surface 34.

The first cover layer 60 is configured to exhibit some kind of color. That is, the first cover layer 60 is not a colorless transparent layer. Providing the first cover layer 60 makes it possible to suppress the first conductor layer 31 from being visually noticed. For this reason, it is possible to suppress the appearance of the structure body 121 from being impaired by the first conductor layer 31. The meaning of "colorless transparent" is that, besides the lack of a color, the transmittance of a beam of light having a wavelength from 150 nm to 400 nm is 95% or greater.

The first cover layer 60 includes at least a first colored layer 61. In the present embodiment, the first colored layer 61 is in contact with the fourth surface 33 and the first side surface 34 of the first conductor layer 31. The first colored layer 61 includes a colorant and a binder resin. For this reason, the color exhibited by the first colored layer 61 is visually perceived as the appearance of the antenna 10. The first colored layer 61 may be in contact with the entire area of the fourth surface 33 and the first side surface 34. Though not illustrated, a layer for enhancing the color-exhibiting property of the first colored layer 61 may be provided between the first colored layer 61 and the first conductor layer 31.

The first colored layer 61 may be configured to exhibit the same color throughout the entire area. For example, the colorant may be distributed uniformly throughout the entire area of the first colored layer 61. The first colored layer 61 may be configured to express some kind of pattern. For example, the colorant may be distributed in the first colored layer 61 in a patterned manner of some kind. The first colored layer 61 may be configured to exhibit one color, or two or more colors. The first colored layer 61 may include a transparent portion.

The colorant may contain organic ink or inorganic ink. Organic ink is a pigment mainly based on an organic compound. Inorganic ink is a natural mineral pigment mainly based on an inorganic compound, or a synthetic inorganic pigment mainly based on an inorganic compound.

In a case where the thickness of the portion of the first colored layer 61 overlapping with the first conductor layer 31 in a plan view is less than the thickness of the portion of the first colored layer 61 not overlapping with the first conductor layer 31 in a plan view as illustrated in Fig. 6, the transmittance the first colored layer 61 overlapping with the first conductor layer 31 is relatively high. In this case, the colorant should preferably contain inorganic ink. This makes it possible to enhance the light-shielding property of the first colored layer 61. For this reason, even in a case where the first colored layer 61 overlapping with the first conductor layer 31 is thin, it is possible to reduce the absolute value of its transmittance sufficiently. For this reason, it is possible to suppress a difference between the transmittance of the first colored layer 61 overlapping with the first conductor layer 31 and the transmittance of the first colored layer 61 not overlapping with the first conductor layer 31. This makes it possible to suppress the pattern of the first conductor layer 31 from being visually noticed.

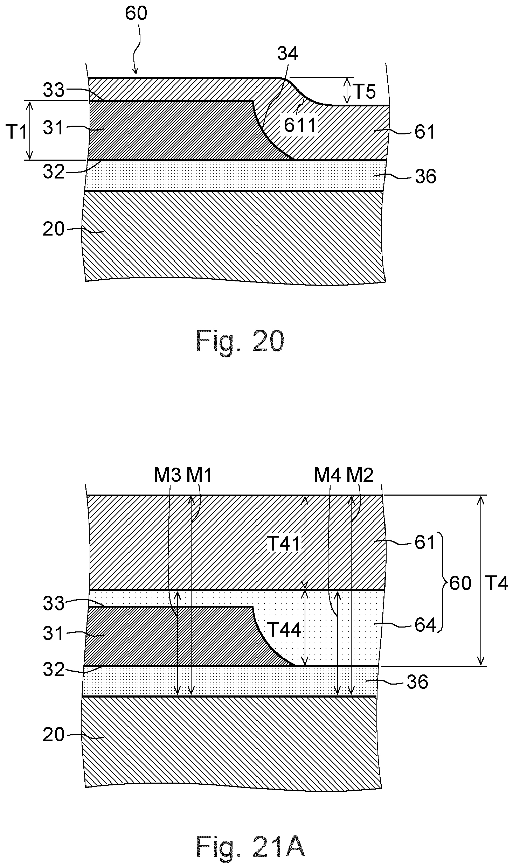

A difference in transmittance attributable to a difference in thickness is less likely to occur in a case where the first colored layer 61 includes a lower surface parallel to the first surface 21 of the base 20 as will be described later while referring to Fig. 21A. In this case, even if the colorant contains organic ink, it is possible to suppress the pattern of the first conductor layer 31 from being visually noticed.

The thickness T4 of the first cover layer 60 is, for example, 5 µm or greater, or may be 10 µm or greater, 20 µm or greater, 50 µm or greater, or 100 µm or greater. The thickness T4 of the first cover layer 60 is, for example, 2 mm or less, or may be 1 mm or less, 500 µm or less, or 200 µm or less.

The thickness T41 of the first colored layer 61 is, for example, 5 µm or greater, or may be 10 µm or greater, 20 µm or greater, or 50 µm or greater. The thickness T41 of the first colored layer 61 is, for example, 500 µm or less, or may be 300 µm or less, or 100 µm or less.

As illustrated in Fig. 6, the upper surface of the first cover layer 60 may be parallel to the first surface 21 of the base 20. For example, the upper surface of the first colored layer 61 may be parallel to the first surface 21 of the base 20. That is, it may be configured such that the influence of the first side surface 34 is not manifested at the upper surface of a layer of the first cover layer 60 that is in contact with the first side surface 34. This makes it possible to suppress the pattern of the first conductor layer 31 from being visually noticed. In a case where the antenna 10 is installed indoors as in commercial facilities, the upper surface of the first cover layer 60 should preferably be parallel to the first surface 21.

With regard to the first cover layer 60 and layers that constitute the first cover layer 60, the term "upper surface" means a surface located at the opposite side in relation to "lower surface". The term "lower surface" means a surface, of the first cover layer 60 and layers that constitute the first cover layer 60, facing the first surface 21 of the base 20.

The meaning of "the upper surface of the first cover layer 60 is parallel to the first surface 21 of the base 20" is that the difference between a first distance M1 and a second distance M2 is 20 µm or less. The first distance M1 is a distance between the upper surface of the first cover layer 60 overlapping with the first conductor layer 31 in a plan view and the first surface 21 of the base 20. The second distance M2 is a distance between the upper surface of the first cover layer 60 not overlapping with the first conductor layer 31 in a plan view and the first surface 21 of the base 20.

The upper surface of the first cover layer 60 should preferably have a small surface roughness. This makes it possible to suppress the antenna 10 from being visually noticed. For example, the surface roughness in maximum height (Rz) of the upper surface of the first cover layer 60 may be 3.0 µm or less, 2.0 µm or less, or 1.0 µm or less. For example, the arithmetic mean roughness (Ra) of the upper surface of the first cover layer 60 may be 3.0 µm or less, 2.0 µm or less, or 1.0 µm or less.

### (Ground)

As illustrated in Fig. 5, the ground 40 includes the second conductor layer 41, which is located at the second surface 22 side with respect to the base 20. The second conductor layer 41 includes a fifth surface 42, which faces the second surface 22 of the base 20, and a sixth surface 43, which is located at the opposite side in relation to the fifth surface 42. The ground 40 includes a second perimeter 40Y located outward of the first perimeter 30Y of the patch 30 in a plan view. The second perimeter 40Y may be congruent with the perimeter 20Y of the base 20.

The second conductor layer 41 contains a material that has conductive property. The material whose examples have been described about the first conductor layer 31 can be used as the material of the second conductor layer 41. The material of the second conductor layer 41 may be the same as the material of the first conductor layer 31 or different therefrom.

The thickness T2 of the second conductor layer 41 may be 1 µm or greater, or 5 µm or greater. The thickness T2 of the second conductor layer 41 may be 35 µm or less, 20 µm or less, or 10 µm or less.

The second conductor layer 41 is opposed to the first conductor layer 31 in the thickness direction of the base 20. This makes it possible to generate an electric field between the first conductor layer 31 and the second conductor layer 41.

### (Second Adhesive Layer)

The second adhesive layer 46 is located between the second surface 22 of the base 20 and the fifth surface 42 of the ground 40. The second adhesive layer 46 bonds the second surface 22 and the fifth surface 42 to each other.

The material whose examples have been described about the first adhesive layer 36 can be used as the material of the second adhesive layer 46. The material of the second adhesive layer 46 may be the same as the material of the first adhesive layer 36 or different therefrom.

The thickness of the second adhesive layer 46 is within the range of the thickness whose examples have been described about the first adhesive layer 36. The thickness of the second adhesive layer 46 may be the same as the thickness of the first adhesive layer 36 or different therefrom.

### (Foundation Layer)

The members located between the third surface 32 of the first conductor layer 31 and the fifth surface 42 of the second conductor layer 41 are also called a foundation layer 50. In the example illustrated in Fig. 5, the foundation layer 50 includes the base 20, the first adhesive layer 36, and the second adhesive layer 46. The foundation layer 50 can be obtained by removing the patch 30 and the ground 40 of the antenna 10 by means of etching or the like.

The relative dielectric constant of the foundation layer 50 may be 4.0 or less, 3.5 or less, 3.0 or less, 2.5 or less, or 2.0 or less. This makes it possible to enhance the radiation efficiency and gain of the antenna 10. The relative dielectric constant of the foundation layer 50 may be 1.0 or greater, or 1.5 or greater.

The dielectric loss tangent tanδ of the foundation layer 50 may be 0.01 or less, 0.005 or less, 0.001 or less, or 0.0005 or less.

The thickness T3 of the foundation layer 50 is, for example, 2 mm or less, or may be 800 µm or less, 500 µm or less, or 200 µm or less. The thickness T3 of the foundation layer 50 is, for example, 10 µm or greater, or may be 20 µm or greater, 50 µm or greater, or 100 µm or greater.

An open-type resonator method can be used as a method for measuring the relative dielectric constant and the dielectric loss tangent. A measurement system that implements the open-type resonator method includes a network analyzer, a millimeter wave multiplier, a millimeter wave detector, and a Fabry-Perot resonator. As the Fabry-Perot resonator, FPR-40, FPR-50, FPR-60, FPR-75, FPR-90, FPR-110, etc. manufactured by KEYCOM Corporation can be used, depending on the frequency.

As a measurement device for measuring the thickness, a length measuring machine, for example, DIGIMICRO manufactured by Nikon Corporation, can be used. In a case where the thickness cannot be measured by means of a length measuring machine, the thickness may be calculated based on an image of a cross section of a sample of the antenna 10. The shape of a cross section of each layer is calculated based on the image. As the measurement device that measures the image, an electron scanning microscope can be used.

The thickness of the antenna 10 as a whole is, for example, 2 mm or less, or may be 800 µm or less, 500 µm or less, or 200 µm or less. The thickness of the antenna 10 as a whole is, for example, 10 µm or greater, or may be 20 µm or greater, 50 µm or greater, or 100 µm or greater.

Next, a method of manufacturing the antenna 10 will now be described.

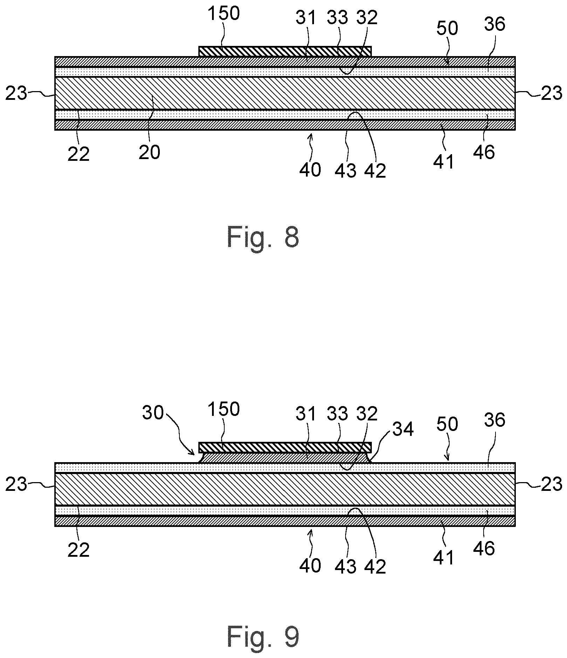

As illustrated in Fig. 8, a laminated body that includes the first conductor layer 31, the base 20, and the second conductor layer 41 in this order is prepared. The laminated body may include the first adhesive layer 36 located between the first conductor layer 31 and the base 20. The laminated body may include the second adhesive layer 46 located between the second conductor layer 41 and the base 20. Next, as illustrated in Fig. 8, a resist layer 150 is formed on the fourth surface 33 of the first conductor layer 31.

Next, as illustrated in Fig. 9, the first conductor layer 31 is processed by wet etching while using the resist layer 150 as a mask. As a result of this processing, the patch 30 is obtained. After that, the resist layer 150 is removed.

Next, the first colored layer 61 is formed on the fourth surface 33 and the first side surface 34 of the first conductor layer 31. For example, a solution that contains a colorant and a binder resin is applied onto the first conductor layer 31 by using a printing method such as an ink-jet method. The solution may be applied onto the first surface 21 of the base 20 or onto the first adhesive layer 36, too. After that, the solution is solidified. For example, the solution is dried. As a result of this processing, the first colored layer 61 is obtained. The antenna 10 that includes the first cover layer 60 that covers the fourth surface 33 and the first side surface 34 of the first conductor layer 31 is manufactured in this way.

When the first colored layer 61 is formed by using a printing method such as an ink-jet method, the first colored layer 61 has a high degree of freedom about design. For this reason, it is easy to impart a color and/or a pattern that is/are well-harmonized with an ambient environment to the first colored layer 61.

When the first colored layer 61 is formed by using a printing method such as an ink-jet method, a step for flattening the upper surface of the first colored layer 61 before curing may be executed. For example, a roller may be rolled in contact with the upper surface of the first colored layer 61 before curing. This makes it possible to reduce the surface roughness of the upper surface of the first colored layer 61.

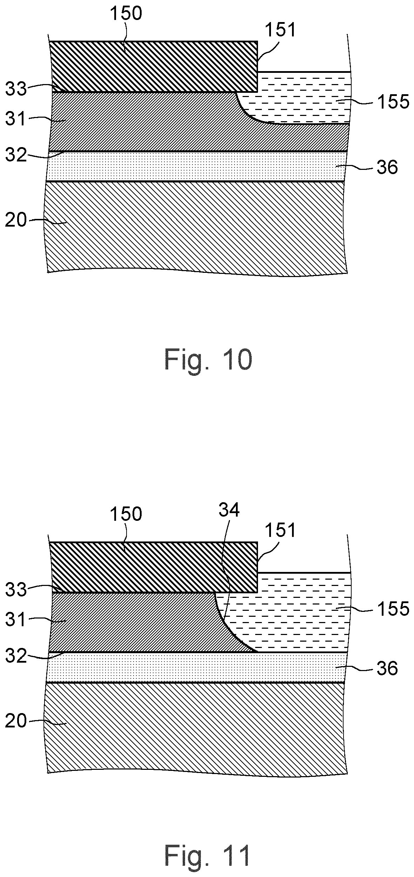

The step of processing the first conductor layer 31 will now be described in detail while referring to Figs. 10 and 11. Figs. 10 and 11 illustrate that the first conductor layer 31 is being etched by means of an etchant 155.

The etching by means of the etchant 155 progresses not only in the thickness direction of the first conductor layer 31 but also in the planar direction of the first conductor layer 31. For example, as illustrated in Fig. 10, in the neighborhood of an end portion 151 of the resist layer 150, a portion, of the first conductor layer 31, being in contact with the resist layer 150 is etched in the planar direction.

The etching of the first conductor layer 31 in the in-plane direction starts at the fourth surface 33. For this reason, the etching in the planar direction at the fourth surface 33 progresses more than the etching in the planar direction at the third surface 32. For this reason, as illustrated in Fig. 11, the first side surface 34 that widens in such a way as to be displaced outward from the fourth surface 33 toward the third surface 32 is formed.

The working effect of the antenna 10 will now be described.

The antenna 10 includes the first cover layer 60 that covers the first conductor layer 31. The first cover layer 60 includes the first colored layer 61 that includes a colorant. For this reason, it is possible to suppress the first conductor layer 31 from being visually noticed. Therefore, for example, it is possible to suppress the appearance of the structure body 121 from being impaired by the first conductor layer 31.

The first side surface 34 of the first conductor layer 31 covered by the first cover layer 60 widens in such a way as to be displaced outward from the fourth surface 33 toward the third surface 32. For this reason, the first side surface 34 is not hidden by the fourth surface 33 in a plan view. This makes it easier for the first cover layer 60 to be in contact with the first side surface 34 when the first cover layer 60 is formed in such a way as to cover the fourth surface 33 and the first side surface 34. For this reason, it is possible to suppress a gap from being formed between the first side surface 34 and the first cover layer 60. This makes it possible to stabilize the characteristics of the antenna 10. For example, it is possible to suppress a change in resonance frequency and radiation efficiency of the antenna 10 in accordance with a change in ambient temperature.

Preferably, the antenna 10 should include the ground 40 located at the second surface 22 side with respect to the base 20. The antenna 10 is attached to the structure body 121 in such an orientation that the ground 40 faces the structure body 121. Since the antenna 10 includes the ground 40, it is possible to suppress the influence of the structure body 121 on the characteristics of the antenna 10. In addition, preferably, the base 20 of the antenna 10 should have flexibility. These features reduce constraints on where and how the antenna 10 is installed. For example, as illustrated in Fig. 2A or 2B, the antenna 10 can be attached along the curved surface profile of the surface 122 of the structure body 121 such as a utility pole. Since the antenna 10 can be installed on various kinds of the structure body 121, the area 125 can be architected easily. This makes it possible to increase the communication capacity of the mobile communication system 100.

As illustrated in Fig. 2A or 2B, when antennas 10 are attached along the curved surface profile of the surface 122 of the structure body 121, it is possible to transmit radio waves in various directions. For example, as illustrated in Fig. 2A or 2B, the normal-line direction of a first antenna 10 is different from the normal-line direction of a second antenna 10 located next to the first antenna 10. For this reason, it is possible to make the direction of a radio wave E1 transmitted from the first antenna 10 also different from the direction of a radio wave E2 transmitted from the second antenna 10. This makes it possible to expand the range of radio-wave transmission directions easily.

Various modifications can be made to the foregoing embodiment. Variation examples will be described below while referring to the drawings where necessary. In the description below, and in the drawings referred to in the description below, the same reference signs as those used for the corresponding portions in the first embodiment will be used for portions that can be configured in the same manner as in the foregoing embodiment, and duplicative explanation will be omitted. When it is evident that working effects obtained in the foregoing embodiment can also be obtained in variation examples, explanation thereof may be not given.

### (First Variation Example)

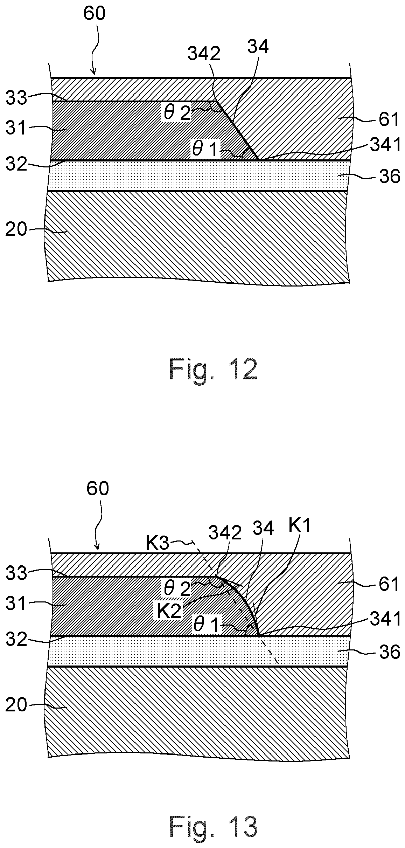

Fig. 12 is a cross-sectional view of the first conductor layer 31 of the antenna 10 according to a first variation example. As illustrated in Fig. 12, the first side surface 34 of the first conductor layer 31 may include a flat surface. The first side surface 34 may be a flat surface that extends from the first end 341 to the second end 342. In this case, the sum of the first angle θ1 and the second angle θ2 is approximately 180°. For example, the sum of the first angle θ1 and the second angle θ2 is 175° or greater and 185° or less. The first side surface 34 that includes a flat surface can be obtained by processing the first conductor layer 31 by, for example, dry etching. The dry retching is, for example, plasma etching, sandblasting, etc.

The term "flat surface" means a surface that extends in a certain direction. For example, the difference between a direction in which the flat surface extends at its upper end and a direction in which the flat surface extends at its lower end is 5° or less. The term "upper end" means the end of the flat surface on the side farther from the base 20. The term "lower end" means the end of the flat surface on the side closer to the base 20. In the example illustrated in Fig. 12, the second end 342 is the upper end, and the first end 341 is the lower end. Therefore, the angle formed by the line tangential to the first side surface 34 at the second end 342 and the line tangential to the first side surface 34 at the first end 341 is 5° or less.

In a case where the first side surface 34 is a flat surface, the first angle θ1 is, for example, 30° or greater, or may be 35° or greater, or 40° or greater. The first angle θ1 is, for example, 60° or less, or may be 55° or less, or 50° or less.

In a case where the first side surface 34 is a flat surface, the second angle θ2 is, for example, 120° or greater, or may be 125° or greater, or 130° or greater. The second angle θ2 is, for example, 150° or less, or may be 145° or less, or 140° or less.

### (Second Variation Example)

Fig. 13 is a cross-sectional view of the first conductor layer 31 of the antenna 10 according to a second variation example. As illustrated in Fig. 13, the first side surface 34 of the first conductor layer 31 may include a curved surface that is convex outward. The meaning of "convex outward" is that, in a cross-sectional view, the first side surface 34 is located outward of the virtual straight line K3 passing through the first end 341 and the second end 342. The first side surface 34 may be an outward curved surface that extends from the first end 341 to the second end 342.

In a case where the first side surface 34 is an outward curved surface, the first angle θ1 is, for example, 45° or greater, or may be 50° or greater, or 55° or greater. The first angle θ1 is, for example, 85° or less, or may be 80° or less, or 75° or less.

In a case where the first side surface 34 is an outward curved surface, the second angle θ2 is, for example, 175° or less, or may be 170° or less, or 165° or less. The second angle θ2 is, for example, 135° or greater, or may be 140° or greater, or 145° or greater.

In a case where the first side surface 34 is an outward curved surface, the sum of the first angle θ1 and the second angle θ2 is greater than 185° but less than 270°. The sum of the first angle θ1 and the second angle θ2 is, for example, 265° or less, or may be 260° or less, or 255° or less. The sum of the first angle θ1 and the second angle θ2 is, for example, 215° or greater, or may be 220° or greater, or 225° or greater.

### (Third Variation Example)

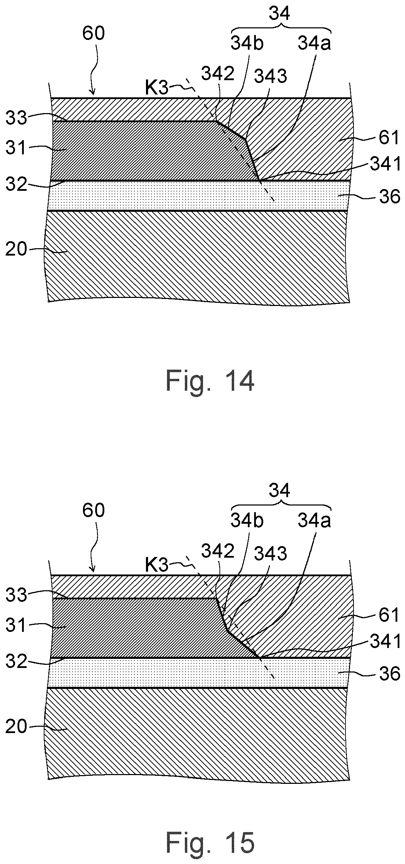

Fig. 14 is a cross-sectional view of the first conductor layer 31 of the antenna 10 according to a third variation example. As illustrated in Fig. 14, the first side surface 34 may include an eleventh side surface 34a and a twelfth side surface 34b that are connected at a first connection portion 343. The eleventh side surface 34a is located between the third surface 32 and the first connection portion 343. The eleventh side surface 34a may extend from the first end 341 to the first connection portion 343. The twelfth side surface 34b is located between the fourth surface 33 and the first connection portion 343. The twelfth side surface 34b may extend from the fourth surface 33 to the first connection portion 343.

The eleventh side surface 34a and the twelfth side surface 34b may be flat surfaces. The planar direction of the eleventh side surface 34a is different from the planar direction of the twelfth side surface 34b. For this reason, at the first connection portion 343, the planar direction of a tangent plane tangential to the first side surface 34 changes in a discontinuous manner.

The eleventh side surface 34a and the twelfth side surface 34b are formed by processing the first conductor layer 31 by, for example, dry etching performed under conditions different from each other.

The eleventh side surface 34a and the twelfth side surface 34b may be connected such that the first connection portion 343 defines an outward convex. The first connection portion 343 may be located outward of the virtual straight line K3 passing through the first end 341 and the second end 342.

### (Fourth Variation Example)

Fig. 15 is a cross-sectional view of the first conductor layer 31 of the antenna 10 according to a fourth variation example. As illustrated in Fig. 15, the eleventh side surface 34a and the twelfth side surface 34b may be connected such that the first connection portion 343 defines an inward convex. The first connection portion 343 may be located inward of the virtual straight line K3 passing through the first end 341 and the second end 342. The eleventh side surface 34a and the twelfth side surface 34b may be flat surfaces. At the first connection portion 343, the planar direction of a tangent plane tangential to the first side surface 34 changes in a discontinuous manner.

### (Fifth Variation Example)

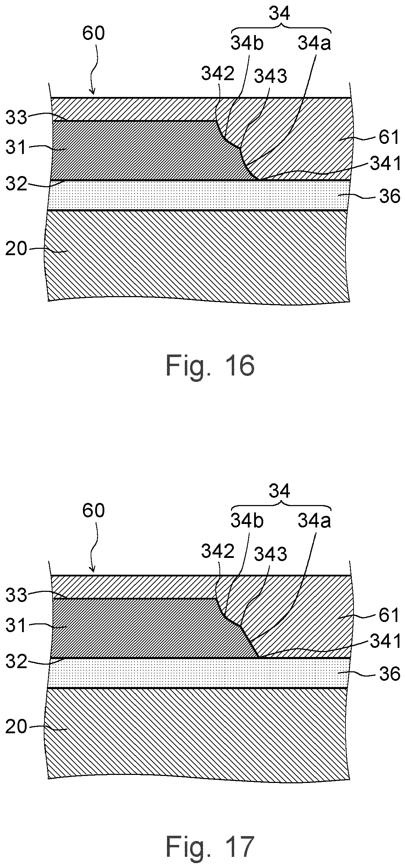

Fig. 16 is a cross-sectional view of the first conductor layer 31 of the antenna 10 according to a fifth variation example. As illustrated in Fig. 16, the eleventh side surface 34a and the twelfth side surface 34b may be inward curved surfaces that are convex inward. At the first connection portion 343, the planar direction of a tangent plane tangential to the first side surface 34 changes in a discontinuous manner.

### (Sixth Variation Example)

Fig. 17 is a cross-sectional view of the first conductor layer 31 of the antenna 10 according to a sixth variation example. As illustrated in Fig. 17, the eleventh side surface 34a may be a flat surface, and the twelfth side surface 34b may be an inward curved surface. Though not illustrated, the eleventh side surface 34a may be an inward curved surface, and the twelfth side surface 34b may be a flat surface. At the first connection portion 343, the planar direction of a tangent plane tangential to the first side surface 34 changes in a discontinuous manner.

### (Seventh Variation Example)

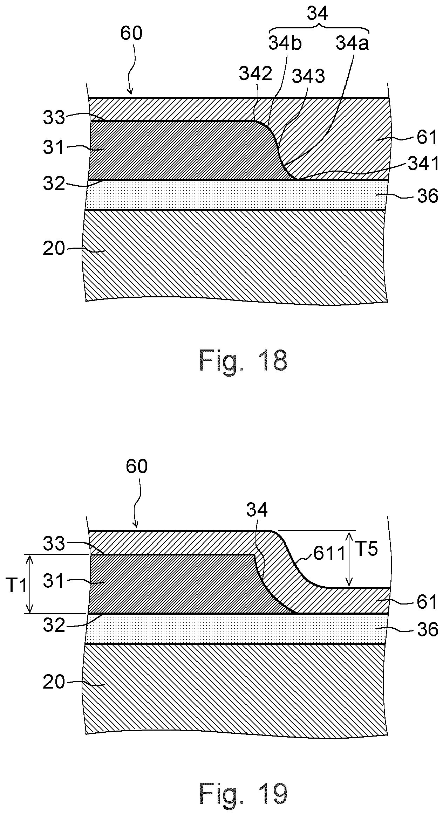

Fig. 18 is a cross-sectional view of the first conductor layer 31 of the antenna 10 according to a seventh variation example. As illustrated in Fig. 18, the eleventh side surface 34a may be an inward curved surface, and the twelfth side surface 34b may be an outward curved surface. Though not illustrated, the eleventh side surface 34a may be an outward curved surface, and the twelfth side surface 34b may be an inward curved surface.

The first side surface 34 may be made up of a non-illustrated combination of the eleventh side surface 34a and the twelfth side surface 34b. For example, the eleventh side surface 34a may be any one of an inward curved surface, an outward curved surface, and a flat surface, and the twelfth side surface 34b may be any one of an inward curved surface, an outward curved surface, and a flat surface.

### (Eighth Variation Example)

In the foregoing embodiment, examples in which the upper surface of a layer of the first cover layer 60 that is in contact with the first side surface 34 is parallel to the first surface 21 of the base 20 have been disclosed. For example, examples in which the upper surface of the first colored layer 61 that is in contact with the first side surface 34 is parallel to the first surface 21 of the base 20 have been disclosed. That is, examples in which the influence of the first side surface 34 is not manifested at the upper surface of a layer of the first cover layer 60 that is in contact with the first side surface 34 have been disclosed.

In this variation example, an example in which the influence of the first side surface 34 is manifested at the upper surface of a layer of the first cover layer 60 that is in contact with the first side surface 34 will be described. Fig. 19 is a cross-sectional view of the antenna 10 according to an eighth variation example. As illustrated in Fig. 19, the upper surface of a layer of the first cover layer 60 being in contact with the first side surface 34 may include a step having a shape corresponding the shape of the first side surface 34. For example, the shape of the first side surface 34, as a step 611 having a shape corresponding thereto, may be observable at the upper surface of the first colored layer 61 that is in contact with the first side surface 34.

In a case where the first colored layer 61 has the step 611, the difference between the thickness of the portion of the first colored layer 61 overlapping with the first conductor layer 31 in a plan view and the thickness of the portion of the first colored layer 61 not overlapping with the first conductor layer 31 in a plan view decreases. For this reason, for example, the difference between the degree of shrinking occurring at the portion of the first colored layer 61 overlapping with the first conductor layer 31 in a plan view and the degree of shrinking occurring at the portion of the first colored layer 61 not overlapping with the first conductor layer 31 in a plan view decreases. This makes it possible to suppress a defect such as cracking in the first colored layer 61. The shrinking of the first colored layer 61 occurs in a step of, for example, heating the first colored layer 61 and curing the first colored layer 61.

In a case where the first colored layer 61 has the step 611, the antenna 10 may be installed outdoors. This makes it possible to suppress the pattern of the first conductor layer 31 corresponding to the step 611 from being visually noticed.

The height T5 of the step 611 may be approximately equal to the thickness T1 of the first conductor layer 31. That is, the stepped shape of the layer of the first cover layer 60 that is in contact with the first side surface 34 may be similar to the shape of the first side surface 34. The height T5 is, for example, 0.7 times or more, or may be 0.8 times or more or 0.9 times or more, the thickness T1.

### (Ninth Variation Example)

Fig. 20 is a cross-sectional view of the antenna 10 according to a ninth variation example. As illustrated in Fig. 20, the stepped shape of the layer of the first cover layer 60 that is in contact with the first side surface 34 may be dissimilar to the shape of the first side surface 34. The height T5 is, for example, less than 0.7 times, or may be 0.6 times or less or 0.5 times or less, the thickness T1. The height T5 may be, for example, 0.1 times or more, 0.2 times or more, or 0.3 times or more, the thickness T1.

### (Tenth Variation Example)

Fig. 21A is a cross-sectional view of the antenna 10 according to a tenth variation example. As illustrated in Fig. 21A, the first cover layer 60 may include a first pressure sensitive adhesive layer 64 located between the first conductor layer 31 and the first colored layer 61. The first pressure sensitive adhesive layer 64 may be in contact with the fourth surface 33 and the first side surface 34 of the first conductor layer 31. The first colored layer 61 may be in contact with the first pressure sensitive adhesive layer 64.

The first pressure sensitive adhesive layer 64 is a layer for attaching the first colored layer 61 to the first conductor layer 31 and the foundation layer 50. The power of adhesion of the first pressure sensitive adhesive layer 64 to the first conductor layer 31 is stronger than the power of adhesion of the first colored layer 61 to the first conductor layer 31. Providing the first pressure sensitive adhesive layer 64 makes it possible to suppress a gap from being formed between the first side surface 34 and the first cover layer 60.

In the present application, the "pressure sensitive adhesive layer" may be a layer that is removable from the target object. Alternatively, the "pressure sensitive adhesive layer" may be a layer that is difficult to be removed from the target object, or a layer that is not expected to be removed from the target object.

The first pressure sensitive adhesive layer 64 may be transparent. The material of the first pressure sensitive adhesive layer 64 is, for example, OCA (optical clear adhesive sheet), a polyester-urethane-based adhesive, or the like.

The thickness T44 of the first pressure sensitive adhesive layer 64 may be greater than the thickness T1 of the first conductor layer 31. The thickness T44 of the first pressure sensitive adhesive layer 64 may be 2 µm or greater, or 5 µm or greater. The thickness T44 of the first pressure sensitive adhesive layer 64 may be 50 µm or less, or 30 µm or less.

The antenna 10 illustrated in Fig. 21A is manufactured by, for example, sticking a decorative sheet that includes the first colored layer 61 and the first pressure sensitive adhesive layer 64 to the first conductor layer 31 and the foundation layer 50. Using the decorative sheet makes it possible to form the first cover layer 60 efficiently.

As illustrated in Fig. 21A, the first colored layer 61 may include a lower surface parallel to the first surface 21 of the base 20. In this case, the thickness of the portion of the first colored layer 61 overlapping with the first conductor layer 31 in a plan view is approximately equal to the thickness of the portion of the first colored layer 61 not overlapping with the first conductor layer 31 in a plan view. This makes it possible to suppress the first conductor layer 31 from being visually noticed.

The meaning of "the lower surface of the first colored layer 61 is parallel to the first surface 21 of the base 20" is that the difference between a third distance M3 and a fourth distance M4 is 20 µm or less. The third distance M3 is a distance between the lower surface of the first colored layer 61 overlapping with the first conductor layer 31 in a plan view and the first surface 21 of the base 20. The fourth distance M4 is a distance between the lower surface of the first colored layer 61 not overlapping with the first conductor layer 31 in a plan view and the first surface 21 of the base 20.

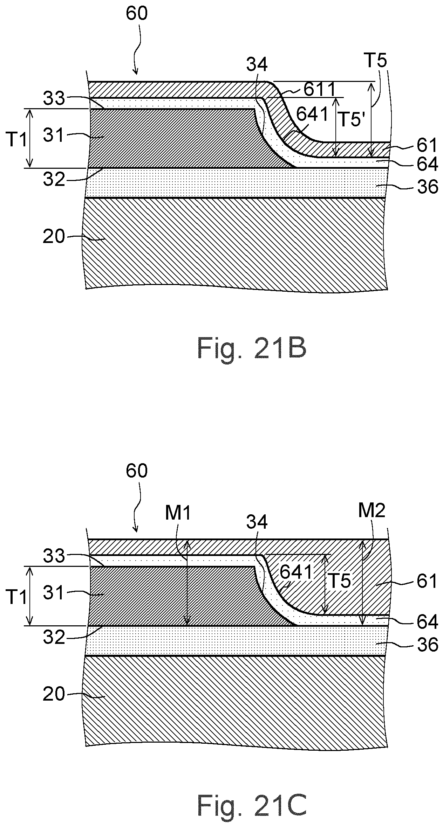

Fig. 21B is a cross-sectional view of an example of the antenna 10 according to the tenth variation example. As illustrated in Fig. 21B, the shape of the first side surface 34, as a step having a shape corresponding thereto, may be observable both at a layer that is in contact with the first side surface 34 and at a layer constituting the upper surface of the first cover layer 60.

The reference sign T5' denotes the height of the step of the layer that is in contact with the first side surface 34. The reference sign T5 denotes the step observable at the layer constituting the upper surface of the layer of the first cover layer 60. Similarly to the eighth variation example, the height of the step T5' and the height of the step T5 may be 0.7 times or more, 0.8 times or more, or 0.9 times or more, the thickness T1. Similarly to the ninth variation example, the height of the step T5' and the height of the step T5 may be 0.7 times or less, 0.6 times or less, 0.5 times or less, 0.1 times or more, 0.2 times or more, or 0.3 times or more, the thickness T1.

In the example illustrated in Fig. 21B, the upper surface of the first pressure sensitive adhesive layer 64 that is in contact with the first side surface 34 includes a step 641 having a shape corresponding to the shape of the first side surface 34. The step 641 has the height T5' mentioned above. In the example illustrated in Fig. 21B, the upper surface of the first colored layer 61 constituting the upper surface of the first cover layer 60 includes the step 611 having a shape corresponding to the shape of the first side surface 34. The step 611 has the height T5 mentioned above.

The first cover layer 60 illustrated in Fig. 21B is manufactured by, for example, sticking a decorative sheet that is thin enough to be able to conform to the shape of the first side surface 34 to the first conductor layer 31 and the foundation layer 50.

Fig. 21C is a cross-sectional view of an example of the antenna 10 according to the tenth variation example. The upper surface of the layer that is in contact with the first side surface 34 may include a step having a shape corresponding to the shape of the first side surface 34, and the upper surface of the layer constituting the upper surface of the first cover layer 60 may be parallel to the first surface 21 of the base 20.

In the example illustrated in Fig. 21C, the upper surface of the first pressure sensitive adhesive layer 64 that is in contact with the first side surface 34 includes the step 641 having a shape corresponding to the shape of the first side surface 34. In the example illustrated in Fig. 21C, the upper surface of the first colored layer 61 constituting the upper surface of the first cover layer 60 is parallel to the first surface 21 of the base 20.

### (Eleventh Variation Example)

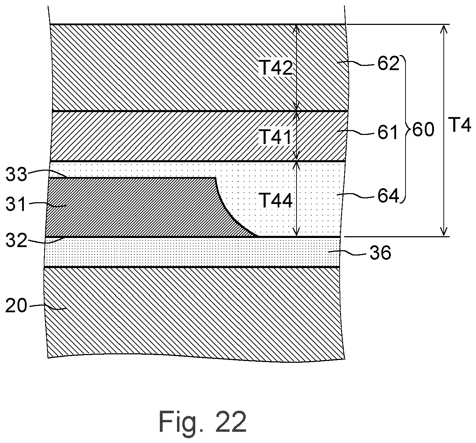

Fig. 22 is a cross-sectional view of the antenna 10 according to an eleventh variation example. As illustrated in Fig. 22, the first cover layer 60 may include a second colored layer 62 located on the first colored layer 61. The second colored layer 62 includes a colorant. The second colored layer 62 may be in contact with the first colored layer 61.

The colorant whose examples have been described about the first colored layer 61 can be used as the colorant of the second colored layer 62. The colorant of the second colored layer 62 may be the same as the colorant of the first colored layer 61 or different therefrom.

The thickness T42 of the second colored layer 62 may be greater than, less than, or the same as, the thickness T41 of the first colored layer 61.

The method of forming the first cover layer 60 in a case where the first cover layer 60 includes a plurality of layers as illustrated in Fig. 22 may be any method. For example, the plurality of layers may be sequentially formed on the base 20 by means of a printing method or the like. For example, a sheet that includes the plurality of layers may be stuck to the base 20.

### (Twelfth Variation Example)

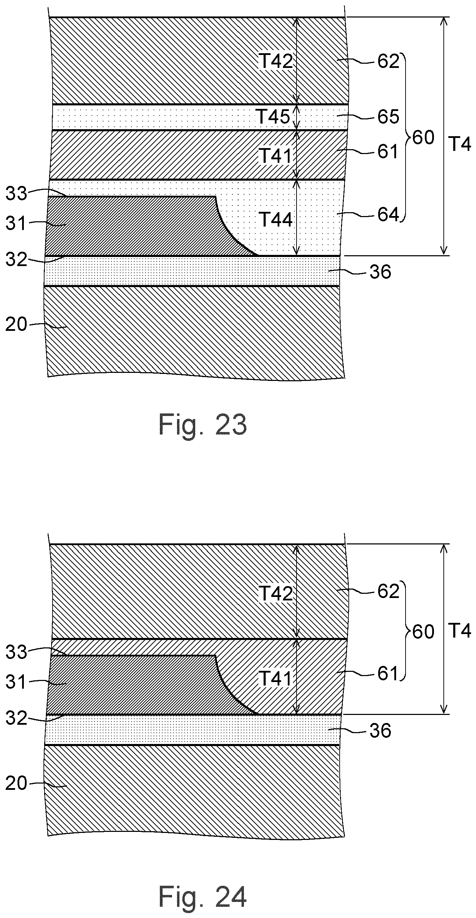

Fig. 23 is a cross-sectional view of the antenna 10 according to a twelfth variation example. As illustrated in Fig. 23, the first cover layer 60 may include a second pressure sensitive adhesive layer 65 located between the first colored layer 61 and the second colored layer 62.

The second pressure sensitive adhesive layer 65 is a layer for attaching the second colored layer 62 to the first colored layer 61. The power of adhesion of the second pressure sensitive adhesive layer 65 to the first colored layer 61 is stronger than the power of adhesion of the second colored layer 62 to the first colored layer 61.

The material whose examples have been described about the first pressure sensitive adhesive layer 64 can be used as the material of the second pressure sensitive adhesive layer 65. The material of the second pressure sensitive adhesive layer 65 may be the same as the material of the first pressure sensitive adhesive layer 64 or different therefrom.

The thickness T45 of the second pressure sensitive adhesive layer 65 may be greater than, less than, or the same as, the thickness T44 of the first pressure sensitive adhesive layer 64.

### (Thirteenth Variation Example)

Fig. 24 is a cross-sectional view of the antenna 10 according to a thirteenth variation example. As illustrated in Fig. 24, the first cover layer 60 may include the first colored layer 61 that is in contact with the fourth surface 33 and the first side surface 34, and the second colored layer 62. The second colored layer 62 may be in contact with the first colored layer 61. A layer(s) such as a pressure sensitive adhesive layer may be provided between the first colored layer 61 and the second colored layer 62.

In the example illustrated in Fig. 24, the first colored layer 61 may have adhesive property in relation to the first conductor layer 31. For example, the power of adhesion of the first colored layer 61 to the first conductor layer 31 may be stronger than the power of adhesion of the second colored layer 62 to the first conductor layer 31.

### (Fourteenth Variation Example)

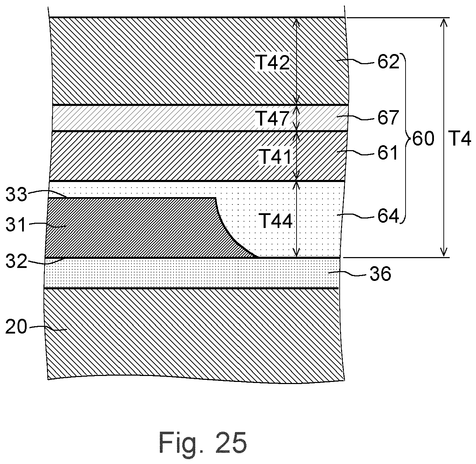

Fig. 25 is a cross-sectional view of the antenna 10 according to a fourteenth variation example. As illustrated in Fig. 25, the first cover layer 60 may include a first transparent layer 67 located between the first colored layer 61 and the second colored layer 62. The first transparent layer 67 is made of a transparent material. The term "transparent" means that the color exhibited by light going out of the first transparent layer 67 is influenced by a layer(s) located between the first transparent layer 67 and the base 20. For example, in the example illustrated in Fig. 25, the color exhibited by light going out of the first transparent layer 67 is influenced by the first colored layer 61. The material of the first transparent layer 67 is, for example, a transparent olefin film, a transparent polypropylene film, or the like.

The thickness T47 of the first transparent layer 67 is, for example, 2 µm or greater, or may be 5 µm or greater. The thickness T47 of the first transparent layer 67 is, for example, 50 µm or less, or may be 30 µm or less.

### (Fifteenth Variation Example)

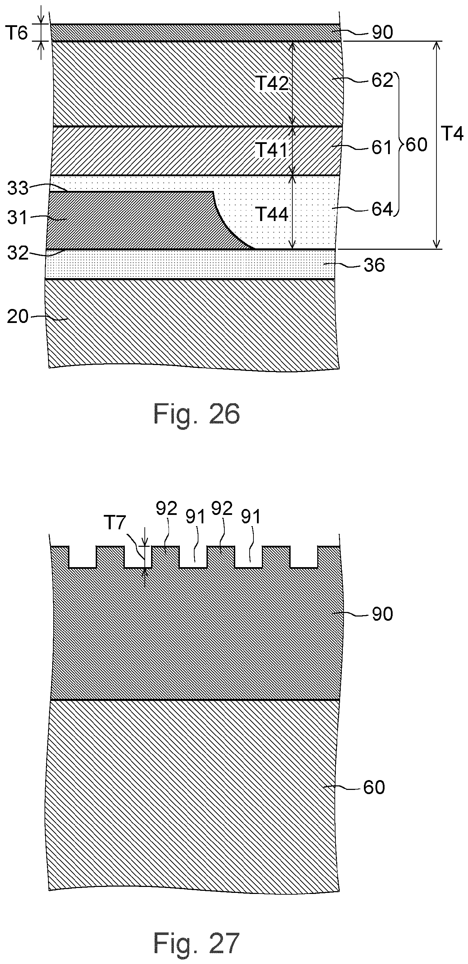

Fig. 26 is a cross-sectional view of the antenna 10 according to a fifteenth variation example. As illustrated in Fig. 26, the first cover layer 60 may include a surface layer 90 constituting the upper surface of the first cover layer 60. The surface layer 90 may have weather resistance. The material of the surface layer 90 is, for example, a UV curable resin, an EB curable resin, or the like.

Weather resistance is property of preventing degradation of the antenna 10 caused by ambient environmental factors. For example, in a case where the antenna 10 is attached to the structure body 121 outdoors, the antenna 10 is subject to various environmental influences such as solar radiation, rainfall, and snowfall. By providing the surface layer 90 that has resistance to changes in environment on the antenna 10, it is possible to enhance the weather resistance of the antenna 10.

The thickness T6 of the surface layer 90 is, for example, 2 µm or greater, or may be 5 µm or greater. The thickness T6 of the surface layer 90 is, for example, 50 µm or less, or may be 30 µm or less.

Fig. 27 is an enlarged cross-sectional view of the surface layer 90. The surface layer 90 may include a concave portion 91 and a convex portion 92. The concave portion 91 and the convex portion 92 may be configured to impart a pattern or a feel to the surface of the antenna 10, may be configured for antireflection, or may be configured to repel stains and bacteria, etc. Though not illustrated, such a concave portion and a convex portion may be formed in/on the upper surface of the first colored layer 61.

The depth T7 of the concave portion 91 is, for example, 100 nm or greater, or may be 200 nm or greater. The depth T7 of the concave portion 91 is, for example, 28000 nm or less, or may be 4800 nm or less. The depth T7 of the concave portion 91 may be constant regardless of position, or may vary depending on position.

### (Sixteenth Variation Example)

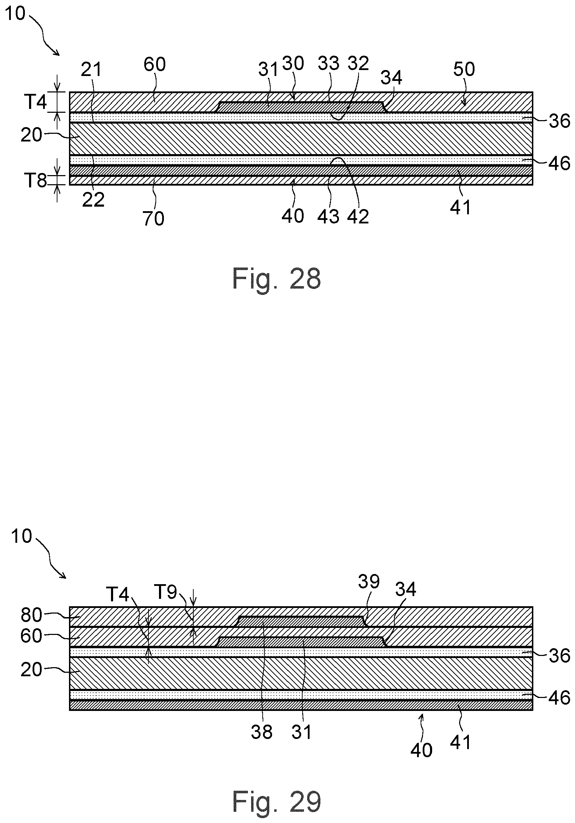

Fig. 28 is a cross-sectional view of the antenna 10 according to a sixteenth variation example. As illustrated in Fig. 28, the antenna 10 may include a second cover layer 70 covering the sixth surface 43 of the ground 40. This makes it possible to enhance at least one of design property or weather resistance of the antenna 10. For example, if the structure body 121 is made of a transparent glass or the like, the second cover layer 70 is visible. By configuring the second cover layer 70 to have an appropriate color, an appropriate pattern, and the like makes it possible to enhance the design property of the antenna 10.

As the layer structure and material of the second cover layer 70, the layer structure and material whose examples have been described about the first cover layer 60 can be used. For example, the second cover layer 70 may include a colorant. The layer structure and material of the second cover layer 70 may be the same as the layer structure and material of the first cover layer 60 or different therefrom. The second cover layer 70 may be made up of a single layer or a plurality of layers.

The thickness T8 of the second cover layer 70 may be within the range of the thickness T4 whose examples have been described about the first cover layer 60. The thickness T8 of the second cover layer 70 may be within the range of the sum of the thickness T4 whose examples have been described about the first cover layer 60 and the thickness T6 whose examples have been described about the surface layer 90. The thickness T8 of the second cover layer 70 may be the same as the thickness T4 of the first cover layer 60 or different therefrom.

### (Seventeenth Variation Example)

Fig. 29 is a cross-sectional view of the antenna 10 according to a seventeenth variation example. As illustrated in Fig. 29, the antenna 10 may include a third conductor layer 38 facing the fourth surface 33 of the first conductor layer 31. The third conductor layer 38 may be located on the first cover layer 60.

The third conductor layer 38 contains a material that has conductive property. The material whose examples have been described about the first conductor layer 31 can be used as the material of the third conductor layer 38. The material of the third conductor layer 38 may be the same as the material of the first conductor layer 31 or different therefrom.

The thickness T9 of the third conductor layer 38 may be 1 µm or greater, or 5 µm or greater. The thickness T9 of the third conductor layer 38 may be 35 µm or less, 20 µm or less, or 10 µm or less.

Though not illustrated, the antenna 10 may include a plurality of third conductor layers 38 overlapping with a single first conductor layer 31 in a plan view. In a case where a plurality of third conductor layers 38 is provided, a layer that has adhesive property, coloring property, transparency, or the like may exist between two third conductor layers 38 located next to each other in a plan view.

The third conductor layer 38 may be a layer that has an influence on the characteristics of the antenna 10. The third conductor layer 38 may be a layer provided for the purpose of enhancing the design property of the antenna 10.

As illustrated in Fig. 29, the antenna 10 may include a third cover layer 80 covering the third conductor layer 38. As the layer structure and material of the third cover layer 80, the layer structure and material whose examples have been described about the first cover layer 60 can be used. For example, the third cover layer 80 may include a colorant. The layer structure and material of the third cover layer 80 may be the same as the layer structure and material of the first cover layer 60 or different therefrom. The third cover layer 80 may be made up of a single layer or a plurality of layers.

The thickness T9 of the third cover layer 80 is within the range of the thickness T6 whose examples have been described about the first cover layer 60. The thickness T9 of the third cover layer 80 may be the same as the thickness T6 of the first cover layer 60 or different therefrom.

In a case where the third conductor layer 38 is a layer that has an influence on the characteristics of the antenna 10, a third side surface 39 of the third conductor layer 38 may be configured to widen in such a way as to be displaced outward toward the first cover layer 60, similarly to the first side surface 34 of the first conductor layer 31. In this case, the third side surface 39 is not hidden in a plan view. This makes it easier for the third cover layer 80 to be in contact with the third side surface 39 when the third cover layer 80 is formed. For this reason, it is possible to suppress a gap from being formed between the third side surface 39 and the third cover layer 80.

### (Eighteenth Variation Example)

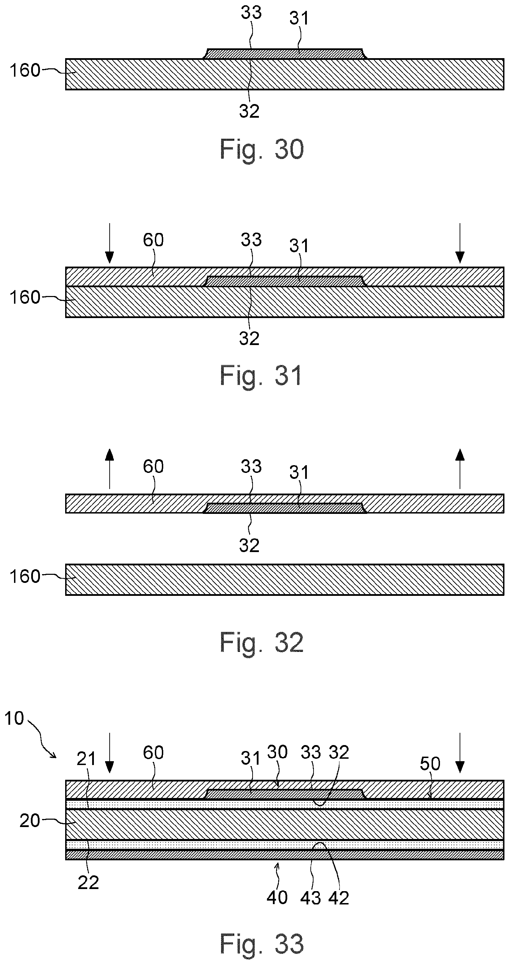

In this variation example, an example of manufacturing the first conductor layer 31 by transfer will be described. Figs. 30 to 33 are diagrams illustrating a method of manufacturing the antenna 10 according to this variation example.

As illustrated in Fig. 30, the first conductor layer 31 is formed on a base 160. The first conductor layer 31 includes the third surface 32 facing the base 160 and the fourth surface 33 located at the opposite side in relation to the third surface 32. Any method may be used for forming the first conductor layer 31. For example, similarly to the foregoing embodiment, the first conductor layer 31 may be formed by wet etching.

Next, as illustrated in Fig. 31, the first cover layer 60 is formed on the base 160 in such a way as to cover the first conductor layer 31. The first cover layer 60 may be formed by printing. The first cover layer 60 may be formed by sticking a decorative sheet or the like to the base 160.

Next, as illustrated in Fig. 32, the first cover layer 60 is detached from the base 160. The power of adhesion of the first cover layer 60 to the first conductor layer 31 is stronger than the power of adhesion of the base 160 to the first conductor layer 31. For this reason, the first conductor layer 31 is also detached together with the first cover layer 60 from the base 160. That is, the first conductor layer 31 is transferred to the first cover layer 60.

Next, as illustrated in Fig. 33, the first cover layer 60 and the first conductor layer 31 are bonded to the foundation layer 50. The antenna 10 that includes the foundation layer 50, the first conductor layer 31, and the first cover layer 60 can be obtained in this way.

### (Nineteenth Variation Example)

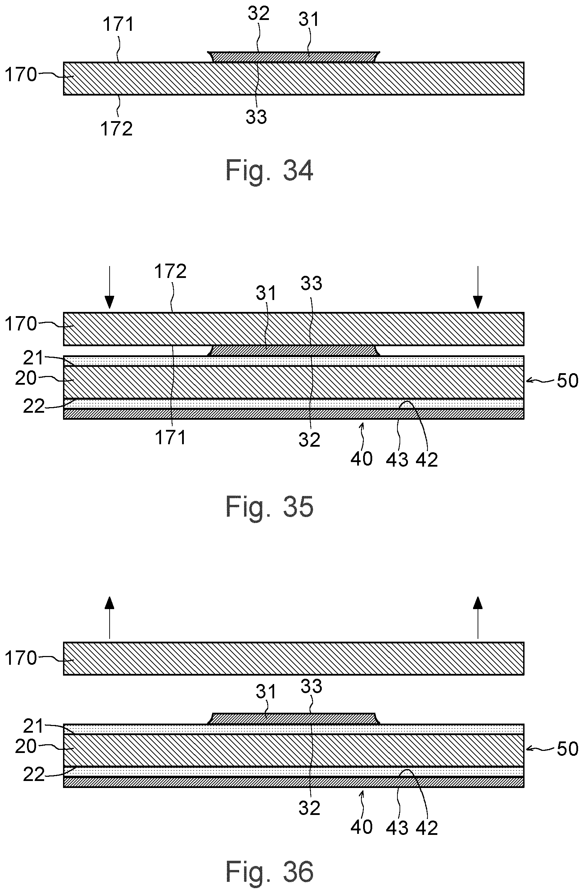

Also in this variation example, an example of manufacturing the first conductor layer 31 by transfer will be described. Figs. 34 to 36 are diagrams illustrating a method of manufacturing the antenna 10 according to this variation example.

As illustrated in Fig. 34, the first conductor layer 31 is formed on a base 170. The first conductor layer 31 includes the fourth surface 33 facing the base 170 and the third surface 32 located at the opposite side in relation to the fourth surface 33. Any method may be used for forming the first conductor layer 31.

Next, as illustrated in Fig. 35, the first conductor layer 31 on the base 170 is brought into contact with the foundation layer 50. Next, as illustrated in Fig. 36, the base 170 is taken away from the foundation layer 50. The power of adhesion of the foundation layer 50 to the first conductor layer 31 is stronger than the power of adhesion of the base 170 to the first conductor layer 31. For this reason, the first conductor layer 31 remains on the foundation layer 50. That is, the first conductor layer 31 is transferred to the foundation layer 50.

Next, the first cover layer 60 is formed on the foundation layer 50 in such a way as to cover the first conductor layer 31. The antenna 10 that includes the foundation layer 50, the first conductor layer 31, and the first cover layer 60 can be obtained in this way.

### (Twentieth Variation Example)

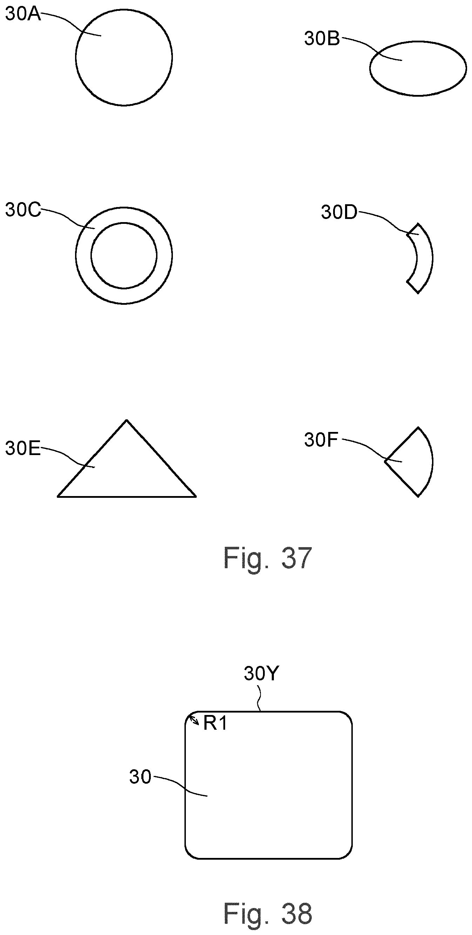

In the foregoing embodiment, examples in which the first perimeter 30Y of the patch 30 extends in the first direction D1 and the second direction D2 orthogonal to the first direction D1 in a plan view have been disclosed. That is, examples in which the shape of the patch 30 in a plan view is a rectangle or a square have been disclosed. However, the shape of the patch 30 in a plan view is not specifically limited. Fig. 37 is a diagram that illustrates examples of the shape of the patch 30 in a plan view.

In Fig. 37, as shown by the reference numeral 30A, the patch 30 may have a circular shape. As shown by the reference numeral 30B, the patch 30 may have an elliptical shape. As shown by the reference numeral 30C, the patch 30 may have a ring shape. As shown by the reference numeral 30D, the patch 30 may have a shape of a part of a ring in the circumferential direction. As shown by the reference numeral 30E, the patch 30 may have a triangular shape. Though not illustrated, the patch 30 may have any other polygonal shape such as a pentagonal or hexagonal shape. As shown by the reference numeral 30F, the patch 30 may have a sector shape.

### (Twenty-first Variation Example)

In a case where the shape of the patch 30 is a polygon in a plan view, as illustrated in Fig. 38, the corners of the patch 30 may be rounded. The curvature radius R1 of the corner is, for example, 1 mm or greater, or may be 2 mm or greater, or 3 mm or greater.

### (Twenty-second Variation Example)

Some examples of the layout of the plurality of patches 30 of the antenna 10 will now be described.

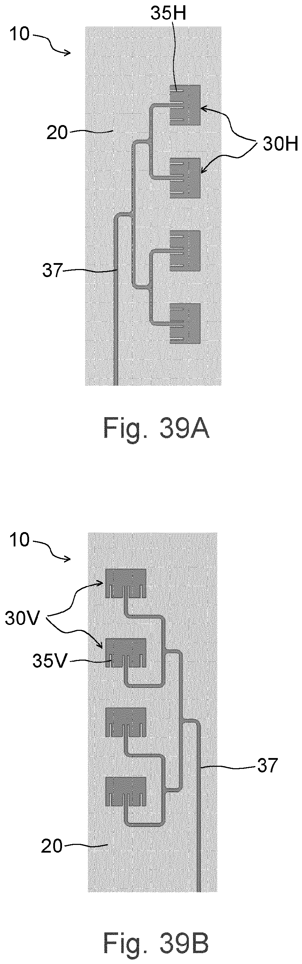

Fig. 39A is a diagram that illustrates an example of the antenna 10. The antenna 10 may include a plurality of patches 30 for horizontal polarization. In the description below, the reference numeral 30H denotes the patches 30 for horizontal polarization. The patches for horizontal polarization 30H may include slits 35H extending in the horizontal direction.

As illustrated in Fig. 39A, the plural patches for horizontal polarization 30H may be arranged in the vertical direction. The plural patches for horizontal polarization 30H may be connected to the same wiring 37. Though not illustrated, the plural patches for horizontal polarization 30H do not necessarily have to be connected to the same wiring 37. For example, individual lines for power supply may be connected respectively to the plural patches for horizontal polarization 30H.

Fig. 39B is a diagram that illustrates an example of the antenna 10. The antenna 10 may include a plurality of patches 30 for vertical polarization. In the description below, the reference numeral 30V denotes the patches 30 for vertical polarization. The patches for vertical polarization 30V may include slits 35V extending in the vertical direction.

As illustrated in Fig. 39B, the plural patches for vertical polarization 30V may be arranged in the vertical direction. The plural patches for vertical polarization 30V may be connected to the same wiring 37. Though not illustrated, the plural patches for vertical polarization 30V do not necessarily have to be connected to the same wiring 37. For example, individual lines for power supply may be connected respectively to the plural patches for vertical polarization 30V.

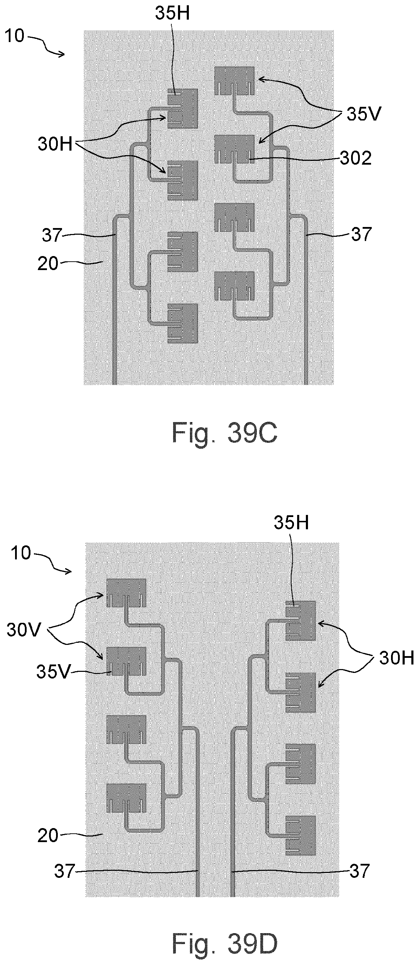

Each of Figs. 39C and 39D is a diagram that illustrates an example of the antenna 10. The antenna 10 may include a plurality of patches for horizontal polarization 30H and a plurality of patches for vertical polarization 30V. As illustrated in Fig. 39C, the antenna 10 may be configured such that the wiring 37 is not located between the patches for horizontal polarization 30H and the patches for vertical polarization 30V. As illustrated in Fig. 39D, the antenna 10 may be configured such that the wiring 37 is located between the patches for horizontal polarization 30H and the patches for vertical polarization 30V.

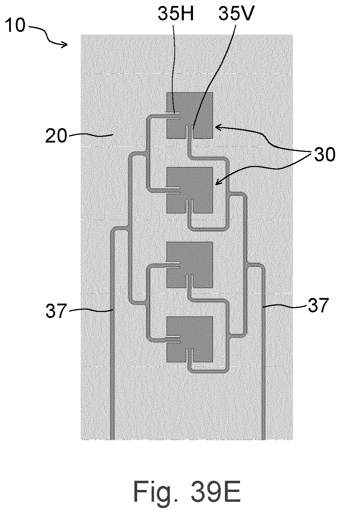

Fig. 39E is a diagram that illustrates an example of the antenna 10. Each of a plurality of patches 30 arranged in the vertical direction may include slits 35H extending in the horizontal direction and slits 35V extending in the vertical direction. In this case, one patch 30 is capable of dealing with both horizontal polarization and vertical polarization.

### (Twenty-third Variation Example)

In the foregoing embodiment, the structure body 121 to which the antenna 10 is attached is a utility pole, but is not limited to this example. For example, the structure body 121 may be a wall, a ceiling, a beam, a pillar, or an inner or outer surface of any other element of an architecture, may be a utility pole, a traffic light, an inner wall of a tunnel, a step of a sidewalk, or an inner or outer surface of any other building, or may be a land surface, a tree, any other natural structural object, or the like. The structure body 121 may be a part of an automobile. For example, the structure body 121 may be a pillar of an automobile. In this case, the communication apparatus 120 that includes the structure body 121 and the antenna 10 may function as a radar for an anti-collision system.

A plurality of variation examples described above may be combined as appropriate to be applied to the foregoing embodiment.

### EXAMPLES

Next, embodiments of the present disclosure will now be explained in more detail by describing Examples; however, embodiments of the present disclosure shall not be construed to be limited to Examples described below unless they are beyond the gist thereof.

### EXAMPLE 1

The characteristics of the antenna 10 illustrated in Fig. 5 were evaluated based on a simulation. Major parameters of a constituting element of the antenna 10 are as follows:
- Relative dielectric constant of the first cover layer 60: ε1, ε2, ε3, (ε1 < ε2 < ε3)
- Thickness of the first cover layer 60: 0 to 200 µm

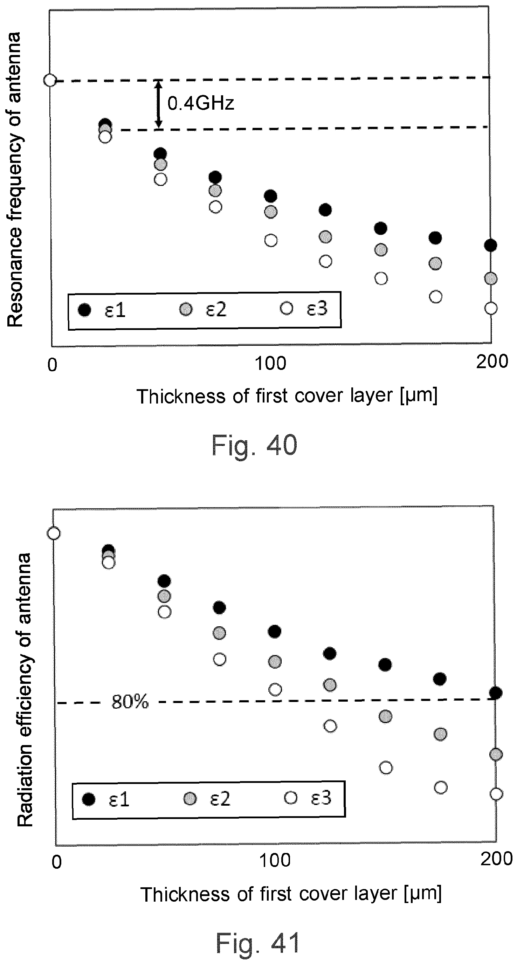

The evaluation result of the resonance frequency of the antenna 10 is illustrated in Fig. 40. The horizontal axis of Fig. 40 represents the thickness of the first cover layer 60. The vertical axis of Fig. 40 represents the resonance frequency of the antenna 10. As illustrated in Fig. 40, the resonance frequency of the antenna 10 becomes lower as the first cover layer 60 becomes thicker. For example, when the thickness of the first cover layer 60 increases from 0 µm to 25 µm, the resonance frequency drops by approximately 0.4 GHz. Therefore, when the first cover layer 60 is provided on the first conductor layer 31, the antenna 10 needs to be designed while taking into consideration a shift in resonance frequency attributable to the first cover layer 60. Note that 0.4 GHz corresponds to a bandwidth assigned to one communication carrier in the 28 GHz band.

The evaluation result of the radiation efficiency of the antenna 10 is illustrated in Fig. 41. The horizontal axis of Fig. 41 represents the thickness of the first cover layer 60. The vertical axis of Fig. 41 represents the radiation efficiency of the antenna 10. As illustrated in Fig. 41, the radiation efficiency of the antenna 10 decreases as the first cover layer 60 becomes thicker. It is said that radiation efficiency of 80% or greater is needed for communication in the 28 GHz band.

### EXAMPLE 2

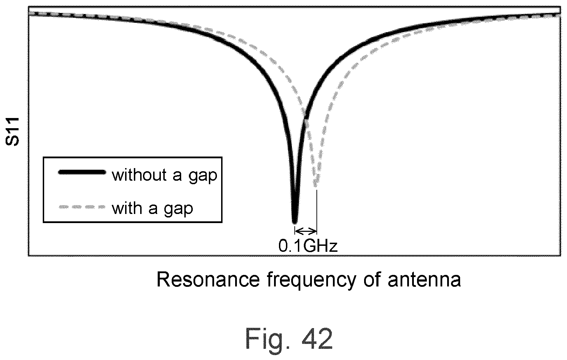

The characteristics of the antenna 10 were evaluated based on a simulation for each of a case where there is no gap between the first side surface 34 and the first cover layer 60 and a case where there is a gap therebetween. The result is shown in Fig. 42. The horizontal axis of Fig. 42 represents the resonance frequency of the antenna. The vertical axis of Fig. 42 represents 511, which is one of S parameters. As shown in Fig. 42, when a gap exists between the first side surface 34 and the first cover layer 60, the resonance frequency at which the peak of S11 appears shifts by approximately 0.1 GHz.

### Reference Signs List

10 antenna
20 base
21 first surface
22 second surface
30 patch
30Y first perimeter
31 first conductor layer
32 third surface
33 fourth surface
34 first side surface
341 first end
342 second end
343 first connection portion
34a eleventh side surface
34b twelfth side surface
35A, 35b slit
36 first adhesive layer
37 wiring
38 third conductor layer
39 third side surface
40 ground
40Y second perimeter
41 second conductor layer
42 fifth surface
43 sixth surface
46 second adhesive layer
50 foundation layer
60 first cover layer
61 first colored layer
62 second colored layer
64 first pressure sensitive adhesive layer
65 second pressure sensitive adhesive layer
67 first transparent layer
70 second cover layer
80 third cover layer
90 surface layer
100 mobile communication system

## Claims

1. An antenna, comprising:
a base that includes a first surface and a second surface located at an opposite side in relation to the first surface;
a first conductor layer that includes a third surface facing the first surface, a fourth surface located at an opposite side in relation to the third surface, and a first side surface located between the third surface and the fourth surface; and
a first cover layer that covers the fourth surface and the first side surface, wherein
the first side surface includes a first end connected to the third surface and a second end connected to the fourth surface,
the first end is located outward of the second end in a plan view, and
the first cover layer includes a first colored layer that includes a colorant.

2. The antenna according to claim 1, further comprising:
a ground that includes a second conductor layer located at the second surface side with respect to the base, the ground including second perimeter located outward of the first side surface in a plan view.

3. The antenna according to claim 1 or 2, wherein
the first side surface includes an inward curved surface located inward of a virtual straight line passing through the first end and the second end in a cross-sectional view.

4. The antenna according to claim 3, wherein
the first side surface forms a first angle with respect to the third surface at the first end,
the first side surface forms a second angle with respect to the fourth surface at the second end, and
a sum of the first angle and the second angle is greater than 90° but less than 175°.

5. The antenna according to claim 4, wherein
the second angle is 135° or less.

6. The antenna according to claim 1 or 2, wherein
the first side surface includes an outward curved surface located outward of a virtual straight line passing through the first end and the second end in a cross-sectional view.

7. The antenna according to claim 6, wherein
the first side surface forms a first angle with respect to the third surface at the first end,
the first side surface forms a second angle with respect to the fourth surface at the second end, and
a sum of the first angle and the second angle is greater than 185° but less than 270°.

8. The antenna according to claim 1 or 2, wherein
the first side surface includes a flat surface.

9. The antenna according to claim 8, wherein
the first side surface forms a first angle with respect to the third surface at the first end,
the first side surface forms a second angle with respect to the fourth surface at the second end, and
a sum of the first angle and the second angle is 175° or greater and 185° or less.

10. The antenna according to claim 1 or 2, wherein
the first side surface includes an eleventh side surface and a twelfth side surface connected to the eleventh side surface at a first connection portion and located between the first connection portion and the fourth surface.

11. The antenna according to claim 10, wherein
the eleventh side surface or the twelfth side surface includes an inward curved surface located inward of a virtual straight line passing through the first end and the second end in a cross-sectional view.

12. The antenna according to claim 10 or 11, wherein
the eleventh side surface or the twelfth side surface includes an outward curved surface located outward of a virtual straight line passing through the first end and the second end in a cross-sectional view.

13. The antenna according to any of claims 10 to 12, wherein
the eleventh side surface or the twelfth side surface includes a flat surface.

14. The antenna according to any of claims 1 to 13, wherein
the first cover layer includes an upper surface parallel to the first surface.

15. The antenna according to claim 14, wherein
the first colored layer includes a lower surface parallel to the first surface.

16. The antenna according to claim 14, wherein
the first cover layer includes a layer that is in contact with the first side surface and includes an upper surface including a step overlapping with the first side surface in a plan view.

17. The antenna according to any of claims 1 to 13, wherein
the first cover layer includes an upper surface including a step overlapping with the first side surface in a plan view.

18. The antenna according to any of claims 1 to 17, wherein
the first colored layer is in contact with the fourth surface and the first side surface.

19. The antenna according to any of claims 1 to 17, wherein
the first cover layer includes a first pressure sensitive adhesive layer located between the first conductor layer and the first colored layer and being in contact with the fourth surface and the first side surface.

20. The antenna according to any of claims 1 to 19, wherein
the first cover layer includes a second colored layer that includes a colorant.

21. The antenna according to claim 20, wherein
the first cover layer includes a second pressure sensitive adhesive layer located between a first colored layer and the second colored layer.

22. The antenna according to claim 20, wherein
the first cover layer includes a first transparent layer located between the first colored layer and the second colored layer.

23. The antenna according to any of claims 1 to 21, wherein
the first conductor layer includes a patch and wiring connected to the patch, and
a slit is formed between the patch and the wiring.

24. The antenna according to claim 23, wherein
the patch is configured to deal with transmission or reception of a radio wave having a frequency of 300 MHz or higher.

25. The antenna according to any of claims 1 to 24, further comprising:
a third conductor layer facing the fourth surface of the first conductor layer.

26. The antenna according to claim 25, further comprising:
a third cover layer covering the third conductor layer, wherein
the third cover layer includes a colorant.

27. A communication apparatus, comprising:
a structure body that includes a surface; and
the antenna according to any of claims 1 to 26, the antenna being attached to the surface.

28. The antenna according to claim 27, wherein
the surface of the structure body includes a curved surface, and
the antenna is attached to a curved surface.
